# EUROPEAN PATENT SPECIFICATION

(11) **EP 1 093 558 B1**
(45) Date of publication and mention of the grant of the patent: **28.04.2004**
(21) Application number: 99932115.1
(22) Date of filing: 30.06.1999
(51) Int. Cl.: F17C 13/04, F17C 7/00

(54) **SYSTEM FOR SUPPLY OF MULTIPLE CHEMICALS TO A PROCESS TOOL**
SYSTEM FÜR DIE ZUFUHR VON MEHREREN CHEMIKALIEN ZU EINER PROZESSVORRICHTUNG
SYSTEME D'ALIMENTATION EN PRODUITS CHIMIQUES MULTIPLES POUR UN OUTIL DE TRAITEMENT

(30) Priority: 30.06.1998 US 91191 P
(43) Date of publication of application: 25.04.2001
(73) Proprietor: ADVANCED TECHNOLOGY MATERIALS, INC., Danbury, CT 06810 (US)
(72) Inventor: NOAH, Craig, M., Mountain View, CA 94043 (US); GREGG, John, N., Marble Falls, TX 78611 (US)
(74) Representative: Viering, Jentschura & Partner
(86) International application number: PCT/US1999/014845
(87) International publication number: WO 2000/000767

(56) References cited:
- WO-A-95/20127
- WO-A-99/02251
- US-A- 5 220 517

## Description

### BACKGROUND OF INVENTION

This invention relates to a chemical delivery system according to the preamble of claim 1 as well as to a method for supplying multiple chemicals to a process tool.

A system of the above-mentioned type is known from US-A-5 620 524.

The chemicals used in the fabrication of integrated circuits must have an ultrahigh purity to allow satisfactory process yields. As integrated circuits have decreased in size, there has been a directly proportional increase in the need for maintaining the purity of source chemicals. This is because contaminants are more likely to deleteriously affect the electrical properties of integrated circuits as line spacing and interlayer dielectric thickness decrease.

One ultrahigh purity chemical used in the fabrication of integrated circuits is tetraethylorthosilicate (TEOS). TEOS has been widely used in integrated circuit manufacturing operations such as chemical vapor deposition (CVD) to form silicon dioxide films. These conformal films are generated upon the molecular decomposition of TEOS at elevated temperatures in plasma enhanced and atmospheric pressure reactors (PECVD, APCVD). TEOS is typically used for undoped, and phosphorous and boron doped interlayer dielectrics, intermetal dielectrics, sidewall spacers, and trench filling applications.

Traditionally, high purity TEOS (and dopants) has been fed to the CVD reaction chamber from small volume quartz containers. More recently, stainless steel containers have been developed, such as described in U.S. Patents 5,465,766; 5,562,132; 5,590,695; 5,607,002; and 5,711,354.
In the production of some electronic devices, multiple chemical compounds have been fed to the reactor so that a layer containing multiple elements may be formed. This has been typically performed by pre-mixing the components and then delivering the mixture to the reactor. For example, TEOS and triethylborate may be fed to the process tool to provide a layer which is in situ doped with boron.

It would be highly desirable to provide a system that enables the delivery of each component separately such that proportions of components at the tool may be readily changed and optimized for the desired result. It would also be desirable to provide a system that enables chemicals to be mixed in the delivery system, prior to introduction into the process tool. It would also be desirable to provide a single unit having a smaller footprint than systems employing multiple dispensing points.

### SUMMARY OF INVENTION

This invention provides a solution to one or more of the needs, disadvantages, and shortcomings described above.

In one aspect this invention concerns a system according is claim 1. Additional canisters, manifolds, and process lines may be added depending on the desired number of chemicals to be delivered by the system. As used herein, "process line" refers to a line that connects directly or indirectly from the system to the process tool which uses the chemicals being supplied by the system. One non-limiting, representative example of a process tool is a CVP reactor. The system may be housed in a single cabinet which provides containment for the chemicals in the canisters and in which the manifolds may be mounted. Typically, the different chemicals are mixed at the tool; however, the chemicals may be optionally mixed in-line before reaching the tool.

In another broad respect, this invention is a method for manufacturing a system for delivery of multiple different chemicals according to claim 10.

In some embodiments, this invention provides a system that enables the delivery of each component separately such that proportions of components at the process tool may be readily changed and optimized for the desired result. In certain embodiments, this invention also provides a system that enables chemicals to be mixed in the delivery system, prior to introduction into the process tool. Furthermore, the systems of this invention may advantageously, in certain embodiments, provide a smaller footprint resulting in cost savings due to exhaust for only one cabinet, simplification of maintenance and support for the system, all as otherwise would be provided by multiple systems each housing only one process canister or one pair of process/refill canisters. For chemicals used in the highest volume in the cabinet (e.g., TEOS), one or both of the canisters may be refilled from a larger bulk system (e.g., from a significantly larger canister as for example a 200 liter canister filling a 5 or 10 gallon canister in the cabinet). This has the added benefit that a fab may be supplied its source of TEOS from the system of this invention if the dedicated TEOS line and source is down.

In another broad respect, this invention is a method for supplying multiple chemicals to a process tool according to claim 17.

Advantageously, the manifolds that may be employed in the practice of this invention may enable improved purge efficiency for low vapor pressure materials and toxic chemicals. The system of this invention may enable supply of multiple chemical reagents at any desired compositional proportion without the need to change out canisters and the like if the proportions are to be changed. The inventors recognized that a need existed for a system that provides multiple chemicals to a process tool and that provides both a process canister and a refill canister for each chemical, all within a single cabinet. Prior systems that were capable of providing multiple chemicals used a single canister for each chemical; hence, prior systems went down when a particular canister had to be changed out. An important advantage of this invention is that all three chemicals can be continuously supplied to a process tool as a given refill canister is being replenished or replaced with a fresh refill canister. This advantage allows a process tool to be continuously supplied and thus the process tool does not go down due to the system being down.

### BRIEF DESCRIPTION OF THE DRAWINGS

FIG. 1 depicts a manifold and canister configuration for delivery and in situ mixing of a plurality of chemicals to a process tool.
FIG. 2A depicts a representative manifold configuration of this invention.
FIG. 2B depicts the path of gas in the manifold while a canister is in service.
FIG. 3 depicts the path of flow in the manifold during a depressurization step to remove the head pressure in the canister.
FIG. 4 depicts the flow of gas in the manifold during a liquid drain.
FIG. 5 depicts the flow of gas in the manifold during a cycle purge.
FIG. 6 depicts a flowing purge in the manifold during a cycle purge.
FIG. 7 depicts another representative manifold configuration of this invention.
FIG. 8 depicts the flow of gas in the manifold of FIG. 7 during a cycle purge.
FIG. 9 depicts a representative cabinet that may house the canisters and manifolds of this invention.
FIG. 10 depicts a non-limiting representative configuration of canisters and manifolds in a cabinet of this invention.
FIG. 11 depicts components of refill manifold 2B and supply manifold 2C.
FIGS. 12 and 12a depict additional manifold and canister configurations for delivery of a plurality of chemicals to a process tool.
FIG 13 depicts one embodiment of a manifold used in the practice of this invention.
FIGS. 14, 14a, 14b, 14c, 14d, 14e and 14f depict various exterior, interior, and cutaway views of a cabinet used in the practice of this invention.

### DETAILED DESCRIPTION OF THE INVENTION

A general description of the metallic canisters, chemical refill system, operating procedures, components, starting manifold system, and so forth, which may be used in the practice of this invention is set forth in U.S. Patents 5,465,766; 5,562,132; 5,590,695; 5,607,002; and 5,711,354, and SN 08/893,913, filed July 11, 1997, the entire contents of which are incorporated by reference herein.

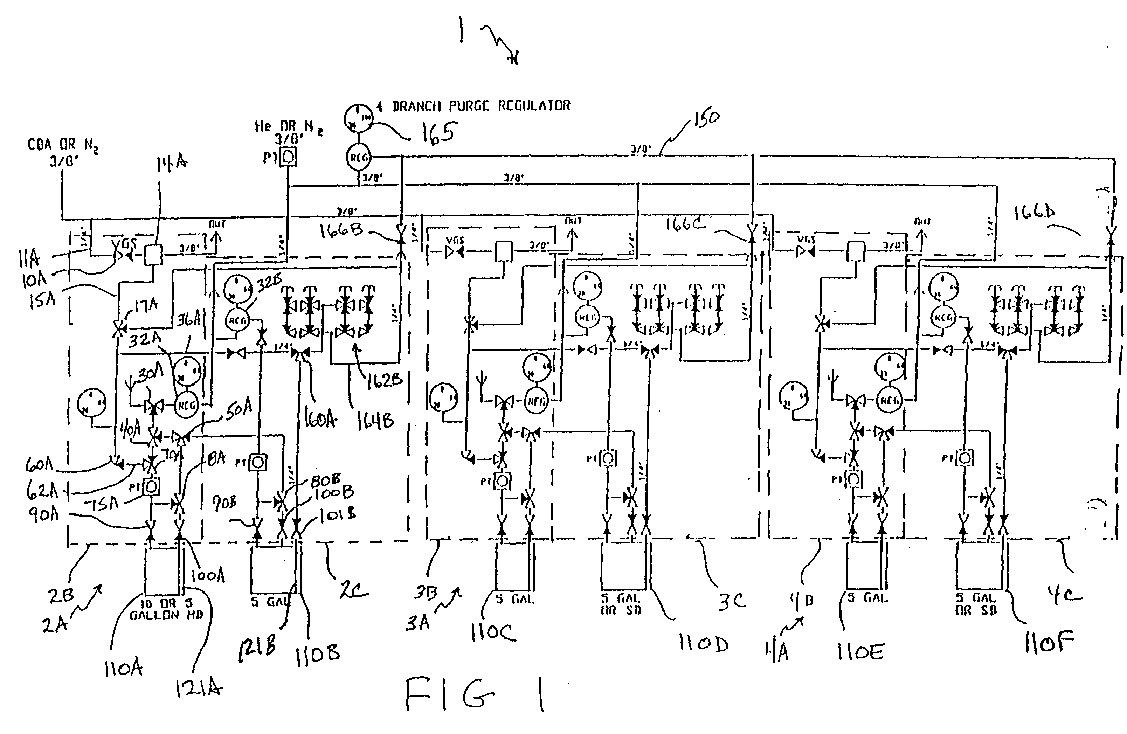

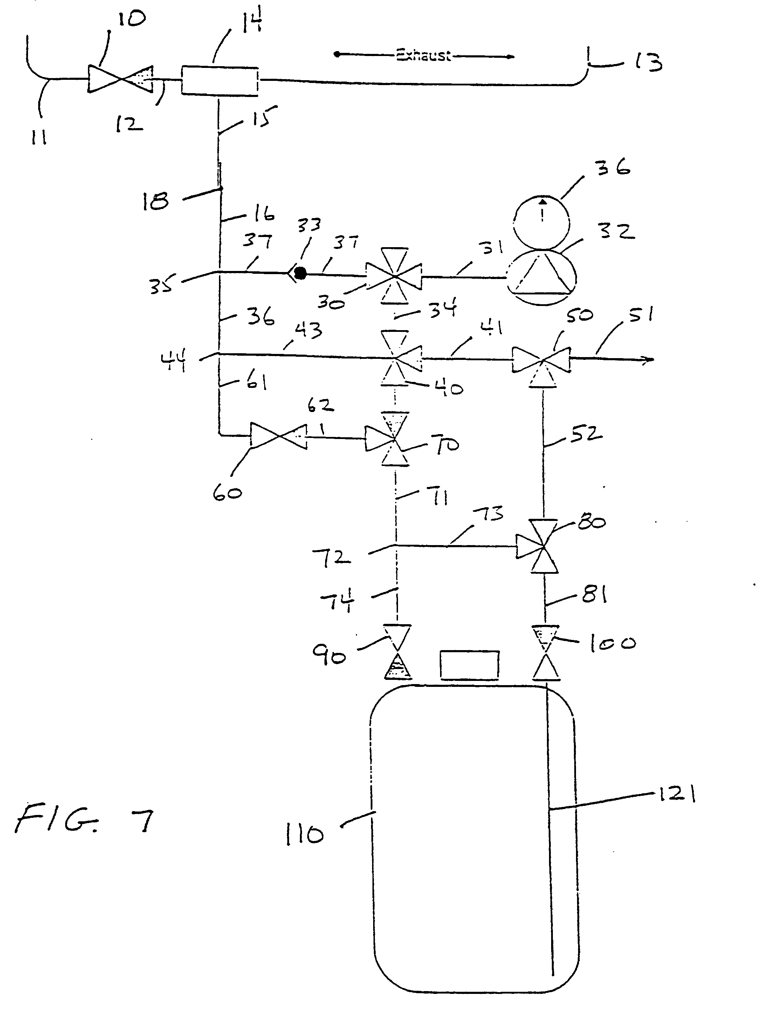

In FIG. 1 there is shown a representative, non-limiting example of a system configuration of this invention. The system 1 in FIG. 1 includes valves and lines which have been numbered to correspond with those of FIG. 7, to the extent there is overlap. FIG. 1 shows a system I that in general provides for refill and delivery of three chemicals. In general, canisters 110A and 110B may contain first chemical, such as TEOS. A manifold 2A includes refill manifold 2B, which connects to canister 110A, and supply manifold 2C which connects to supply canister 110B. Dotted lines 2B and 2C outline the refill and supply manifolds. In addition, system 1 includes manifolds 3A and 4A which comprise refill manifolds 3B and 4B and supply manifolds 3C and 4C, respectively. Refill manifolds 3B and 4B connect to canisters 110C and 110E, with supply manifolds 3C and 4C connecting to supply canisters 110D and 110F.

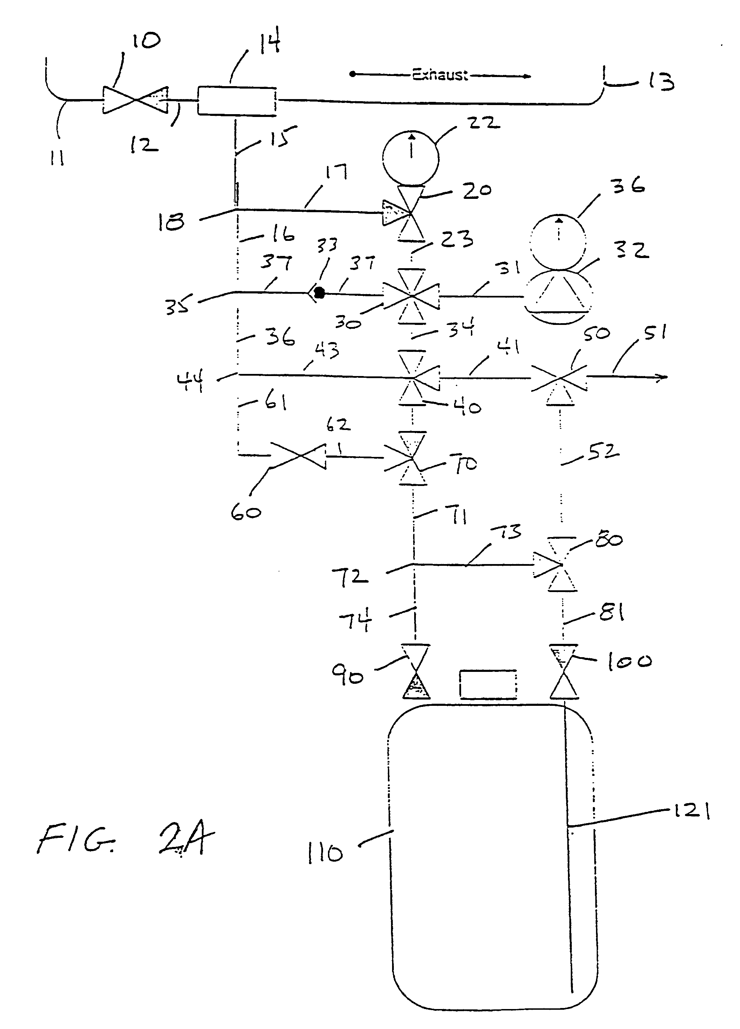

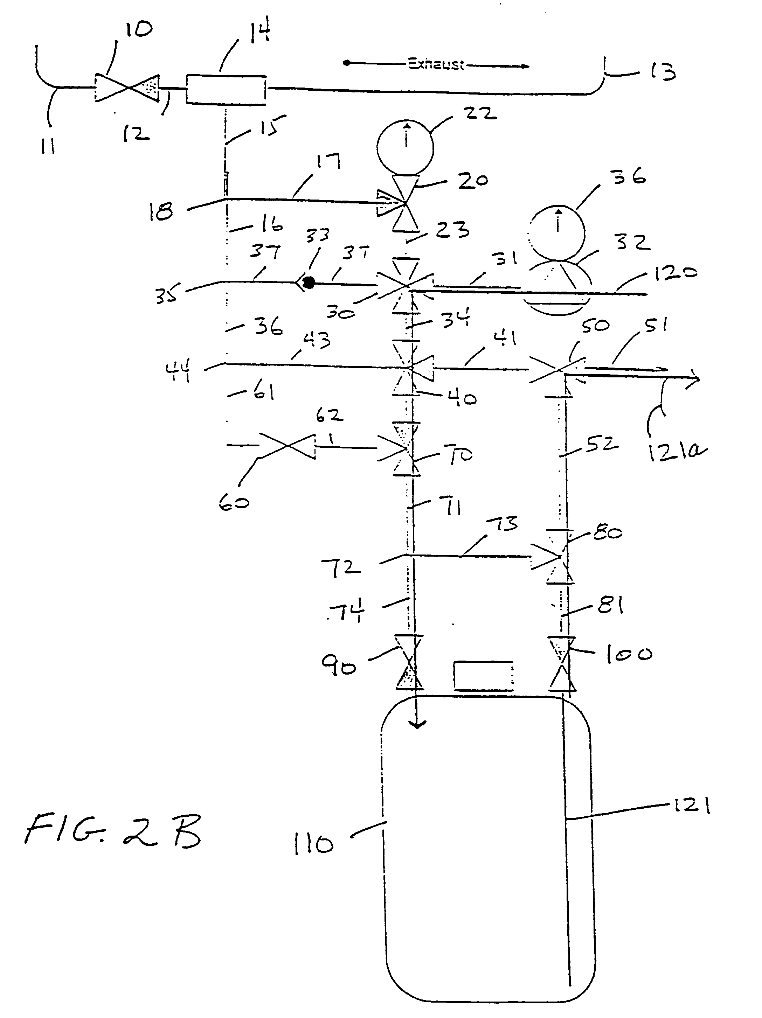

The system configuration in FIG. 1 employs three essentially identical manifolds 2A, 3A, and 4A. However, the individual manifold designs may vary widely, both individually and overall. For instance, while FIG. 1 depicts use of refill manifold 2B which corresponds to that shown in FIG. 7, the system 1 may instead employ the manifold shown in FIG. 2A or in U.S. Patents in U.S. Patents 5,465,766; 5,562,132; 5,590,695; 5,607,002; and 5,711,354, incorporated herein by reference. The supply manifolds, likewise, may be of different design.

By increasing head pressure in supply canister 110B, liquid chemical may be forced out through line 121B, CI 101B, four branch supply valve 160A to four branch supply manifold 162B from which chemical is distributed to one or more process tools. Output lines may be connected to any of the four exit ports of the four branch supply manifold 162B, with such output lines leading to a canister, a valve manifold box containing another four branch supply manifold, or a process tool. Non-limiting examples of valve manifold boxes are described in U.S. Patent application Serial Number 09/046,907, filed May 24, 1998, incorporated herein by reference. Chemical may be dispensed from supply canisters 110D and 110F by a similar procedure. Chemical may be delivered to a process tool by use of a pump that withdraws chemical from the supply canisters rather than pushing, mechanical pressure, via a pneumatic cylinder, or via a bag of chemical in a canister that has pressure applied to it, or via a bag in the canister which supplies the pressure as by filling the bag with gas or liquid. In FIG.1, vacuum can be provided via open valve 17A to the four branch manifold 162B while the four branch manifold continues to provide chemical. It should be appreciated that the branched supply manifold 162B uses four branch valves, a supply manifold may use any number of valves. For instance, the branched supply manifold may employ two or more branch valves. Although there is no limit as to the number of branch valves in the branched supply manifold, typically the number of valves is 10 or less. It should be noted that the branched supply manifold is connected to and in communication with the process line.

Additional advantages of this invention include the controlling of valve sequence and flow of gas via a single control unit, with further economy from the capability of controlling a the system by a single off-site computer facilitated by use of a single process control unit in the system.

During a refill cycle, a controller (not shown) actuates valves such that pressurized gas is released by regulator 32A and flows through CGI 30A, CBV 40A, CP2 70A, and CI 90A into canister 110A. Similarly, line drain and flowing purge may be facilitated by introduction of inert gas through line 164B via regulator 165 and through valves 166B, 166C, and 166D. FIG. 1 also shows a pressure transducer 75A which serves to monitor pressure in the system.

In systems having two pressure transducers, the capability of balancing pressure in the system is improved. In this way, the configuration allows incremental release of head pressure off a process canister by closing 90B, pulling a vacuum on the line, closing off the vacuum, then opening 90B CI to incrementally drop pressure in the process canister. It should be noted that head pressure in the process canister is too high, refill of the process canister becomes problematic if not impossible. It is typically desirable for the process canister to have a pressure that is lower than the pressure in the refill canister by at least 34,4738 kN/m² (5 psig). Reducing head pressure through practice of this invention may be automated and occur sequencially and in situ during use of the system.

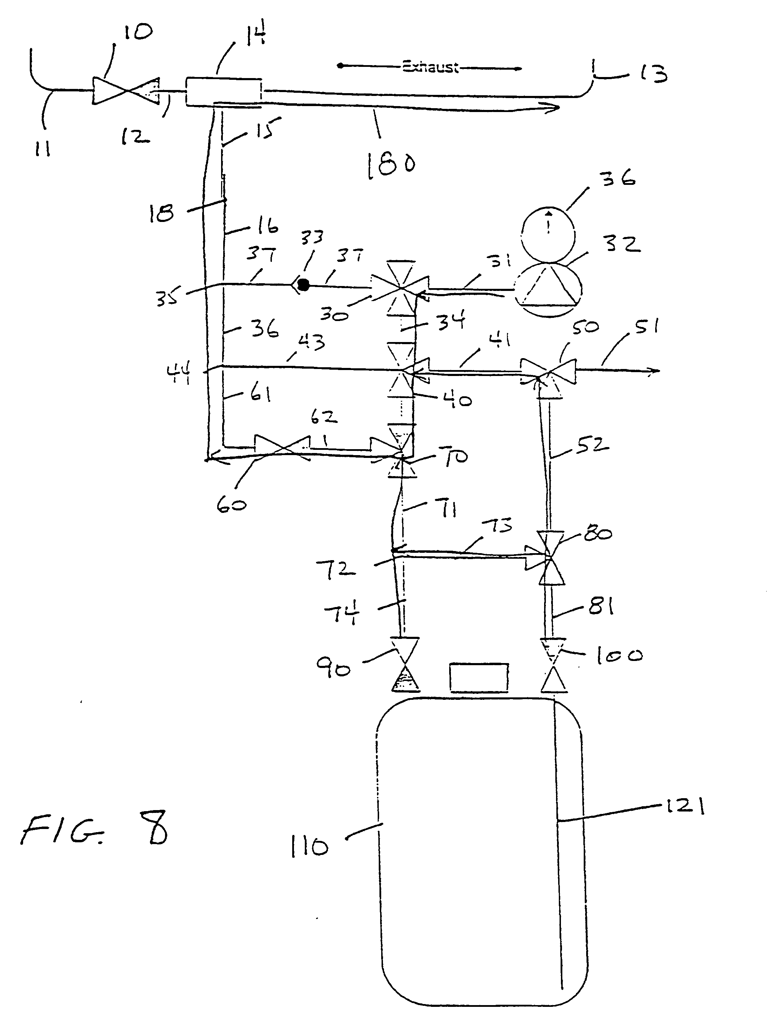

The refill manifolds 2B, 3B, and 4B may be subjected to depressurization, liquid drain, vacuum, and flowing purge steps according to the procedures described below in connection with FIGS. 7 and 8. The depressurization, liquid drain, vacuum, and flowing purge steps may be effected on the supply manifolds 2C, 3C, and 4C through appropriate actuation of the refill manifolds.

In FIG. 2A there is shown a manifold system of this invention. In FIG. 2A, a vacuum source 14 such as a Venturi vacuum generator may be connected to vacuum supply valve ("VGS") 10 via line 12. VGS 10 functions to control the flow of gas (such as nitrogen, . - helium, or argon) via inert gas line 11 to the vacuum source 14 if the vacuum source is a Venturi vacuum generator. Vacuum source 14 may also be attached to exhaust line 13 which exits to exhaust. Vacuum source 14 may be connected to low pressure vent valve ("LPV") 20, carrier gas isolation valve ("CGI") 30, canister bypass valve ("CBV") 40, and control valve ("CP3") 60. For each of the valves in the FIGS., the open triangles represent lines which are always open, with the darkened triangles being closed until opened. In FIG. 2A, vacuum source 14 is connected to LPV 20 via line 15, tee 18, and line 17; to CGI 30 via line 15, tee 18, line 16, tee 35, and line 37; to CBV 40 via line 15, tee 18, line 16, tee 35, line 36, tee 44, and line 61. Check valve 33 in line 37 is closed unless and until the manifold eclipses the desired release pressure. Hence, vacuum source 14 is typically closed off to CGI 30 via line 37. Generally, the check valve 33 may be set to activate if the manifold pressure surpasses about 100 pounds per square inch. The check valve serves to vent gas if pressure in the system reaches a selected level. The function of LPV 20 is to control venting and evacuation of manifold and canister during start-up and canister change-out. Vacuum gauge 22 may also be connected to LPV 20. Vacuum gauge 22 may function to monitor vacuum during purge cycles. Line 23 may connect LPV 20 to carrier gas isolation valve ("CGI") 30. Line 31 may connect CGI 30 to regulator 32 which may supply a flow of pressurized inert gas. A delivery pressure gauge 36 may be tied into regulator 32 to monitor regulator pressure and pressure during all operations.

In FIG. 2A, line 34 may connect CGI 30 to CBV 40. Line 41 and 42 may attach CBV 40 to process line isolation valve ("PLI") 50 and to control valve ("CP2") 70. The function of PLI 50 is to control the flow of chemical out of the manifold. CGI 30 functions to control the pressurized gas supply to the manifold. The function of CBV 40 is to control the supply of pressure or vacuum to PLI 50 and to line 71. Line 51 may carry chemicals to either a device outside the system, or to another canister to be refilled. Line 52 may serve to link PLI 50 to control valve ("CP1") 80. Line 61 may connect control valve 60 to control valve 70. From control valve 70, line 71 may lead to tee fitting 72, with lines 73 and 74 running from tee 72 to control valve 80 and canister inlet ("CI") 90, respectively. CI 90 functions to control pressurization and evacuation of a canister. Control valve 80 may link to canister outlet ("CO") 100 via line 81. CO 100 functions to control the flow of chemical from a canister 110 during chemical delivery and the purging of the canister outlet weldment during canister changes. CI 90 and CO 100 serve to couple the manifold to the corresponding structures on a supply canister, such as male and female threaded joints. Fittings to join the manifold to canister 110 are typically present between CI 90 and tee 72, and between CO 100 and CP1 80. If CO 100 is a dual activator valve, tee 72 can be shifted down to directly connect with CI 90, such that a line connects the dual activator directly to CI 90.

Canisters 110 may be loaded with a variety of chemicals, and are typically burdened with high purity chemicals for use in semiconductor manufacture. For example, the canisters may contain TEOS, arsenic compounds, titanium compounds, boron compounds, and so forth. In one embodiment of this invention, the canister 110 is at least partially filled with a chemical which is at least 99.9999% pure based on the amount of trace metals in the chemical.

The aforementioned lines, which may also be referred to as conduits, tubing, pipes, passages, and the like, may be constructed of metal tubing, for example, such as stainless steel tubing. Each of the valves may be conventional pneumatically actuated valves, such as a NUPRO 6L-M2D-111-P-III gas control valve. Likewise, the regulator can be a standard type, such as an AP Tech 1806S 3PW F4-F4 V3 regulator. The system may be assembled using conventional methods, such as by using pressure fitting valves, by welding, and the like. The valves may be controlled using conventional process control such as an Omron programmable controller box wired to a touch screen control panel. Alternatively, the valves may be controlled using an ADCS APC™ Controller which incorporates an imbedded microprocessor for command sequence execution, with software residing on an EPROM. The control unit, for example, may control flow of pressurized gas to open or close pneumatic valves.

During use, the manifold of this invention may be operated as follows. To push chemical out of the canister 110 to the delivery point, the valves in the manifold are appropriately opened and closed to pressurized gas into the system and into the canister. In FIG. 2B, line 120 illustrates the path of pressurized gas entering canister 110, with line 121 showing the path of liquid chemical exiting canister 110 through a dip tube 111. Thus, pressurized gas from a source (not shown) is released by regulator 32 into line 31. The gas thereafter passes through open CGI 30, then through line 34, CBV 40, line 71, CI 90, and into canister 110. Pressure from entering gas forces liquid chemical up the dip tube, and through CO 100, line 81, CP1 80, line 52, PLI 50, and out line 51 to the receiving point.

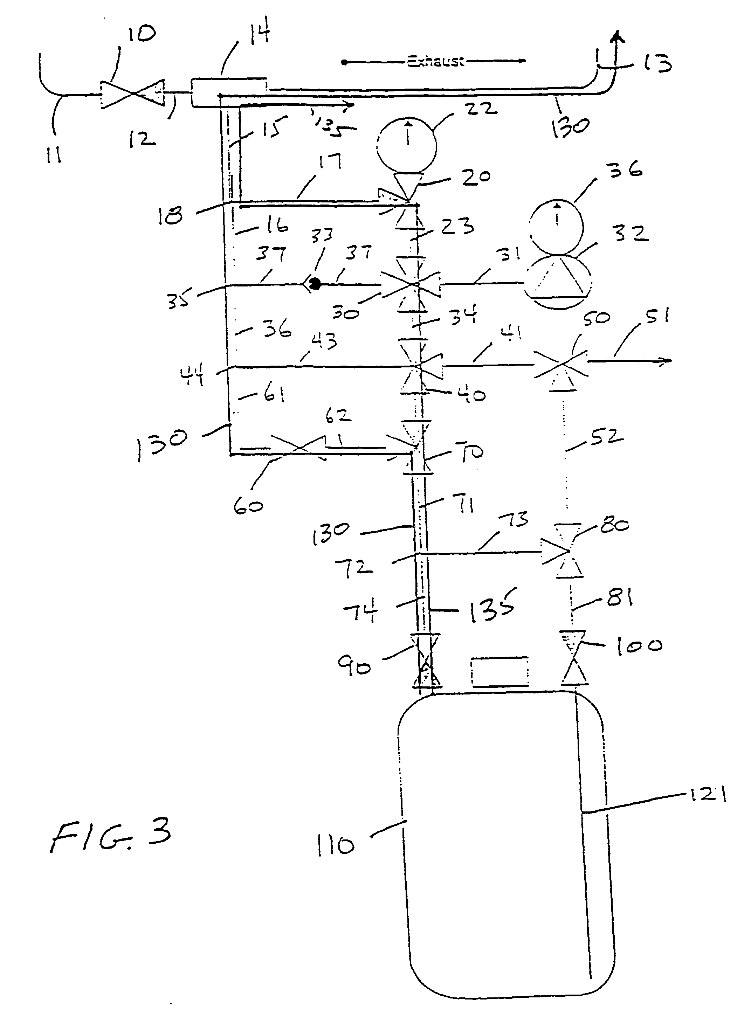

When a supply canister (even a full canister) is being changed out, the lines may be purged to rid the manifold of residual chemicals. The first step is depressurization, which functions to remove the head pressure in canister 110. Depressurization may be affected in a few ways. For example, two procedures by which depressurization may occur are depicted in FIG. 3. In one depressurization method, depicted by solid line 130, VGS 10 is opened to allow gas to flow from line 11 through line 12 and into vacuum source 14 such that a vacuum is generated with the flow exiting via line 13 to exhaust. The vacuum which is generated in source 14 pulls a vacuum on line 15, tee 18, line 16, tee 35, line 36, tee 44, line 61, through open CPI 60, line 62, CP2 70, line 71, tee 72, line 74, and open CI 90, thereby pulling a vacuum on the head space of canister 110. Alternatively, depressurization can be affected by opening LPV 20, CP2, and CI 90 so that the vacuum is pulled via solid line 135.

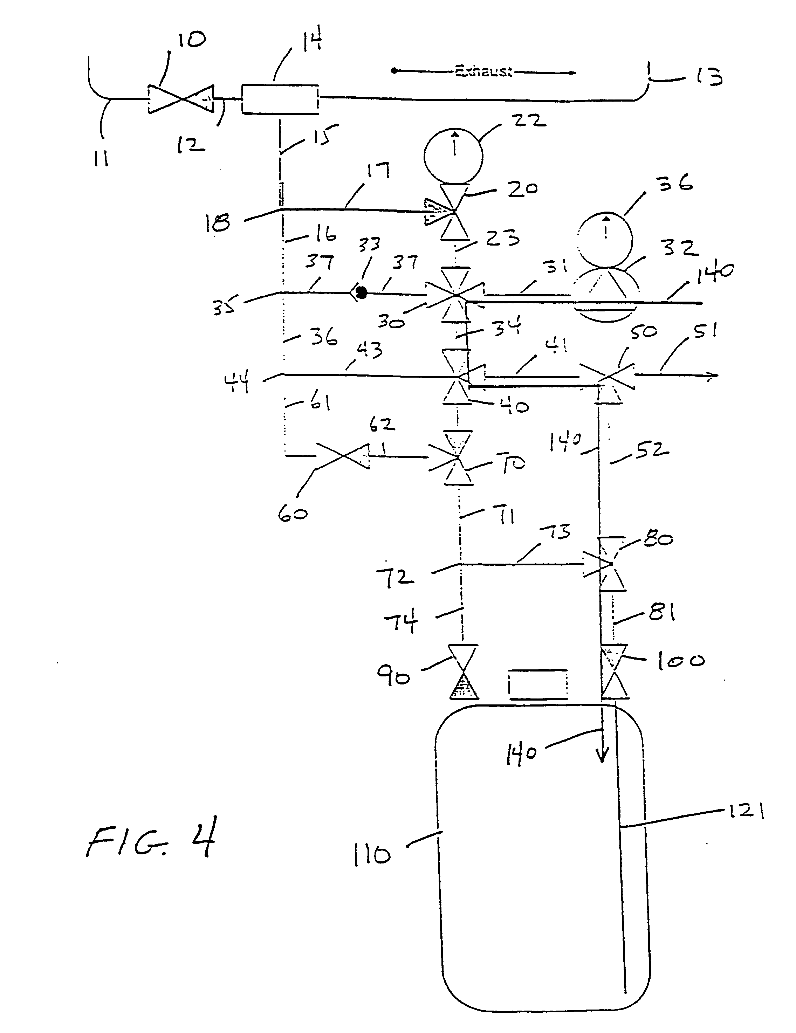

After depressurization, a liquid drain instituted to clear the lines (weldments) of liquid. Thus, in FIG. 4 gas is introduced via regulator 32 into line 31. CGI 30, CBV 40, and CO 100 are open such that gas flows through lines 34, 41, 52, and 81 such that liquid chemical is forced back into canister 110. The flow of gas during the line drain is illustrated by solid line 140.

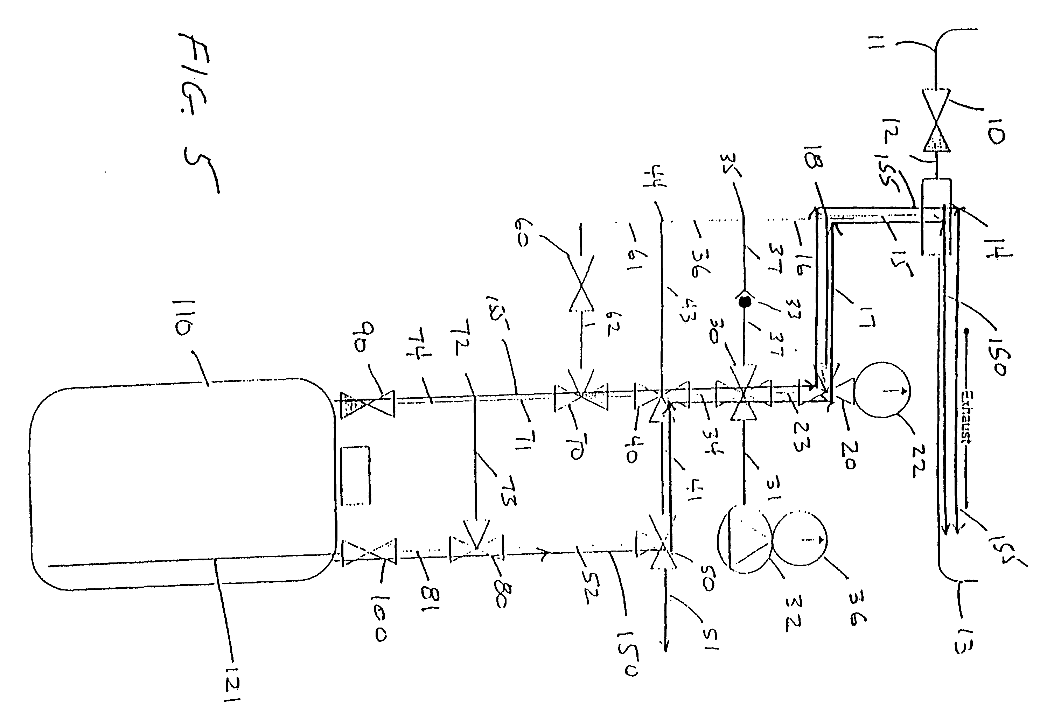

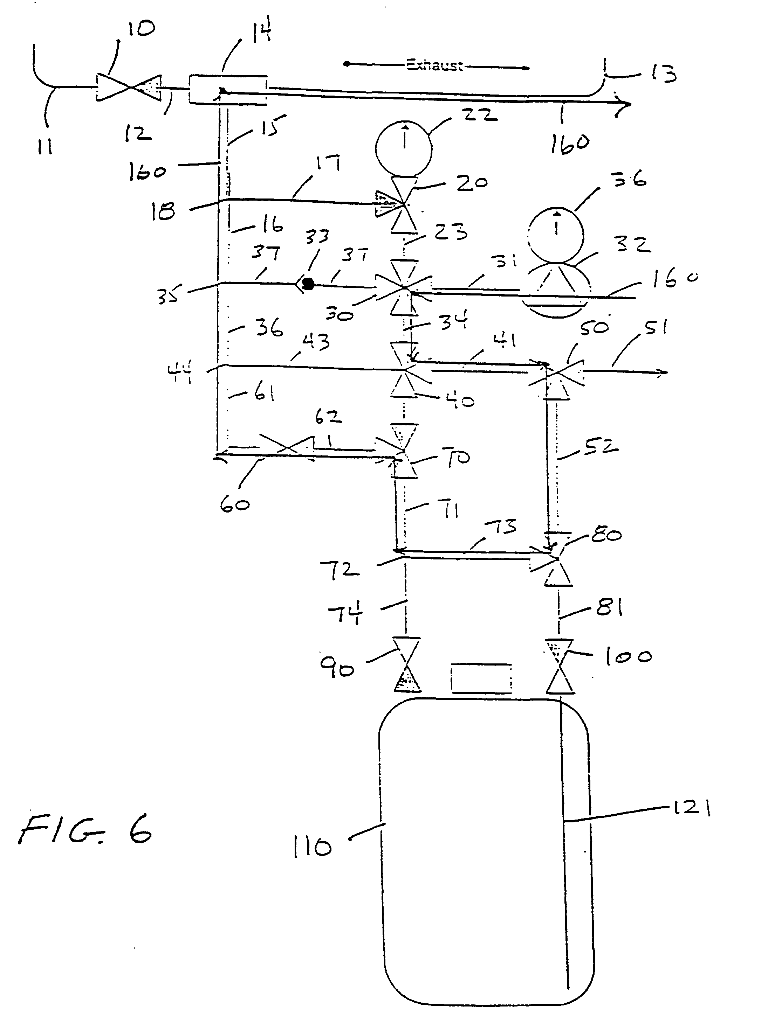

Thereafter, a cycle purge is instituted which includes a vacuum step and a flowing purge step as illustrated in FIGS. 5 and 6, respectively. The vacuum step may be accomplished in a variety of ways, including via the configurations depicted by solid lines 150 and 155 in FIG. 5. Thus, in one embodiment, CBV 40 and LPV 20 is open such that when VGS 10 is opened to allow gas into vacuum source 14 via lines 11 and 12, a vacuum is drawn out to exhaust via line 13, with a vacuum thus being pulled on lines 15, 17, 23, 34, 41, 52, and 81. Alternatively, LPV 20 and CP2 70 are open such that a vacuum is pulled on lines 15, 17, 23, 34, 42, 71 and 74. In addition, LPV 20, CP2 70 and CBV 40 can all be open such that a vacuum is pulled on lines 42, 71, and 74 as well as on lines 41, 52, and 81. The openings can be alternated so that lines 42/71/74 and 41/52/81 are intermittently evacuated.

In FIG. 6, a flowing purge of the cycle purge is illustrated. In FIG. 6, regulator 32 allows pressurized gas to enter line 31. With CGI 30, CBV 40, CP1 80, and CP1 60 open (note CI 90 and CO 100 are closed), the gas flows through lines 34, 41, 52, 73, 71, 62, 61, 36, 16, 15, and 13 to thereby purge the manifold, as depicted in FIG. 6 by solid line 160. LPV 20 may be intermittently opened so that lines 23 and 17 may be purged. After purge, the fittings are typically broken while a positive pressure on the manifold is maintained so that moisture does not enter the manifold. For instance, CGI 30, CBV 40, and CP2 70 may be opened so that gas flows out lines 74 and 81 after the fittings are broken. After a new canister is seated, the purge cycle is typically repeated to remove any water or other contaminant that might have entered the manifold, as well as any water in the fittings and weldments of the new canister.

In FIG. 7 there is shown an alternative embodiment of this invention which is similar to the embodiment depicted in FIG. 1 except that LPV 20, lines 17 and 23, and gauge 22 are absent. If CO 100 is a dual activator valve, tee 72 can be shifted down to directly connect with CI 90 and control valve 80 directly attached to the dual activator, such that a line connects the dual activator directly to CI 90 and such that the number of potential dead legs in the manifold is reduced. In the embodiment shown in FIG. 7, line 43 to CBV 40 may be optionally removed. The same flow scheme shown in FIG. 2 may be employed to push chemicals out of canister 110 for the configuration in FIG. 7. Depressurization of the configuration shown in FIG. 7 may be accomplished using the flow scheme depicted as line 130 in FIG. 3. The liquid drain depicted as solid line 140 in FIG. 4 may then be employed for the configuration of FIG. 7. The vacuum step may be accomplished as set forth in FIG. 8 as depicted by line 180. The flowing purge of FIG. 6 may be used for the configuration in FIG. 7. The embodiment of the invention has many advantages including a reduced number of valves which results in lower cost of the manifold, a reduction in the number of points where a leak may occur as well as a reduction in the chances for valve failure for a given manifold. This embodiment also reduces the number of dead legs in the system, resulting in a more effective flowing purge.

The types of chemicals which may be transferred using the delivery system of this invention may vary widely depending on the type of process tool and desired outcome. Non-limiting examples of representative chemicals include tetraethylorthosilicate ("TEOS"), triethylphosphate, trimethyl phosphite, trimethyl borate, titanium tetrachloride, tantalum compounds, and the like; solvents such as chlorinated hydrocarbons, ketones such as acetone and methylethylketone, esters such as ethyl acetate, hydrocarbons, glycols, ethers, hexamethyldisilazane ("HMDS"), and the like; solid compounds dispersed in a liquid such as barium/strontium/titanate cocktails (mixtures). These examples of chemicals are not intended to be limiting in any way. The chemicals may be of a variety of purities, and mixtures of chemicals can be used. In one embodiment, a single type of chemical is employed. A given chemical may advantageously have a purity of 99.999% or more with respect to trace metals. If dispersions are employed, it is preferable to flush the lines out with liquid solvents such as triglyme or tetrahydrofuran (THF) so that compounds are not precipitated in the lines when the lines are depressurized. Additionally, for any of the embodiments of this invention, it is contemplated that the manifold can be heated to accelerate evaporation of chemicals in the lines. In this regard, the manifold can be maintained in a heated environment, wrapped with heating tape connected to a variac or the like. To facilitate evaporation during a flowing purge, heated gas could alternatively be employed, such as heated argon, nitrogen, or other inert gas. Similarly, a vaporizer for chemicals containing solid active components may be interposed at a point in the process line. U. S. Patent 5,362,328 incorporated herein by reference, describes a non-limiting example of a vaporizer. Combinations of these techniques can also be employed. For some types of chemicals, it may be possible to purge with reactive chemicals, which react with one or more of the compounds in the line to produce more readily evacuated compounds.

Advantageously, the system of this invention may be used to deliver three or more chemicals to a process tool which uses the mixture of chemicals. The system of this invention may thus provide chemicals to any process tool which requires a chemical during its use. Such process tools may include apparatuses for chemical vapor deposition, photolithography, and etch applications. These process tools are frequently used in the fabrication of electronic devices such as integrated circuits, memory circuits, flat panel display, possibly fiber optic manufacturing, multichip modules (e.g., "MCMs"), and so forth. In addition, it should be appreciated that while this invention may be used to supply a chemical such as TEOS to a process tool such as a CVD reactor used in the fabrication of integrated circuits, memory devices, and the like, the system may be used in other processes.

A pressure transducer may be added on a spare port of the canister to allow for pressure management control to keep an inlet valve for helium or the like closed during operation and to only open when the volume is down.

The manifolds of this invention may include a sensor attached, for example, in line 15 to determine whether the lines manifold contains chemicals. Similarly, a sample port could be included in line 15 where a sample of gas from the line can be withdrawn and tested using an analytical device to test for the presence of the chemical.

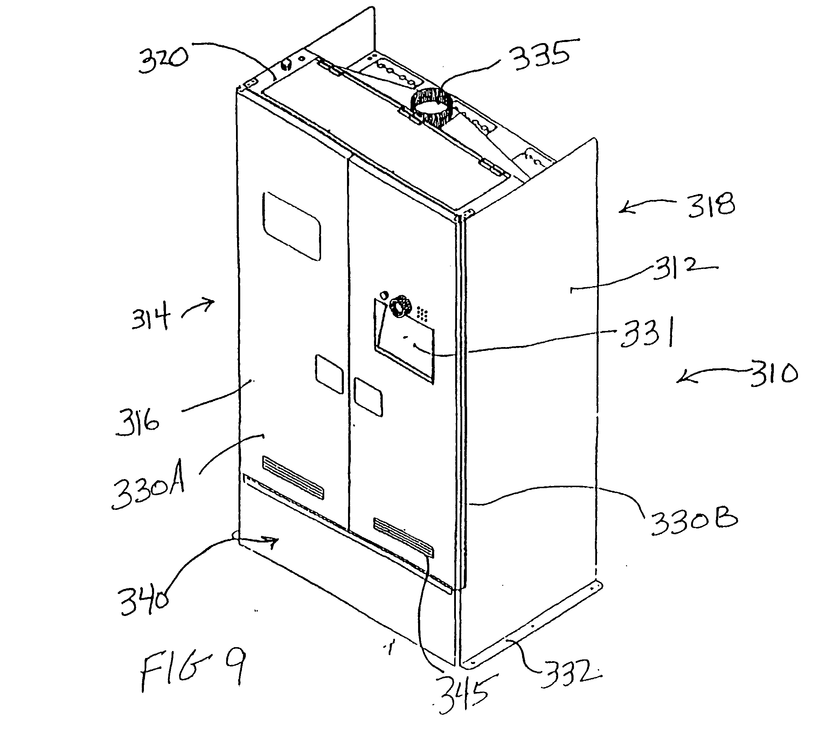

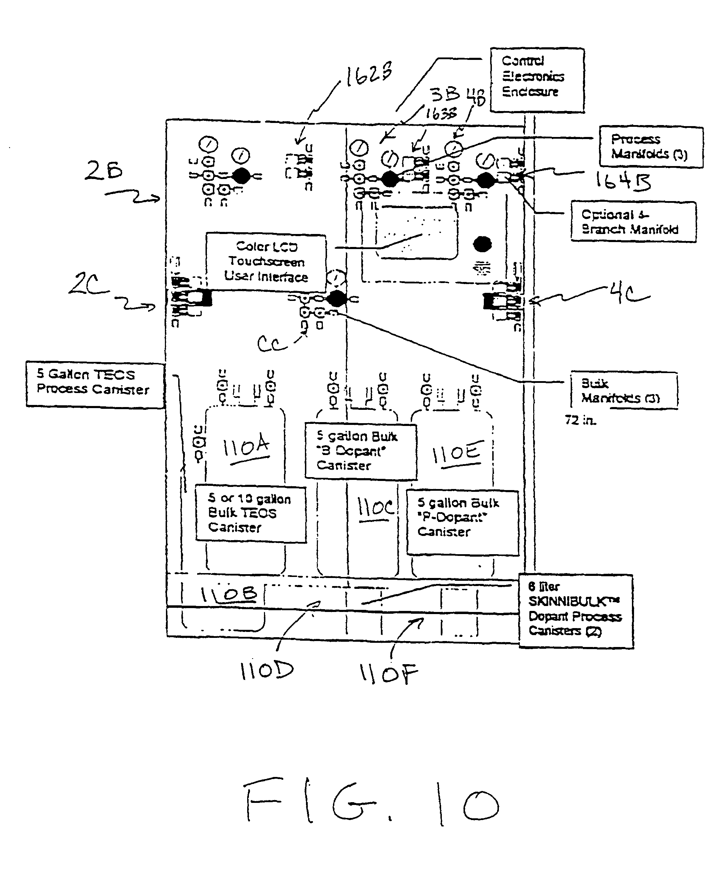

In FIG. 9 there is shown a non-limiting representative example of a cabinet 310 that may be used in the practice of this invention. The cabinet 310 may include front 316, sides 312 and 314 (not shown), and back (not seen) 318 panels, together with top 320 and bottom (not shown). The dimensions and configuration of the sides may vary widely depending on the size, number, and configuration of the canisters and manifolds. For example, while the canisters may be arranged in pairs, two deep, as in FIG. 10, a single canister can be used for each chemical or the paired canisters may be positioned side by side as observed from the front. Referring to FIG. 9, the cabinet may include a variety of advantageous components, such as a set of doors 330A and 330B, a user interface 331 such as a color liquid crystal display touchscreen, vent port 335, base 340 that serves as a containment reservoir in the event of a chemical spill, and lower ventilation slits 345 for influx of air flow into the cabinet. Optional flange 332 may be employed to affix the cabinet 310 to the floor.

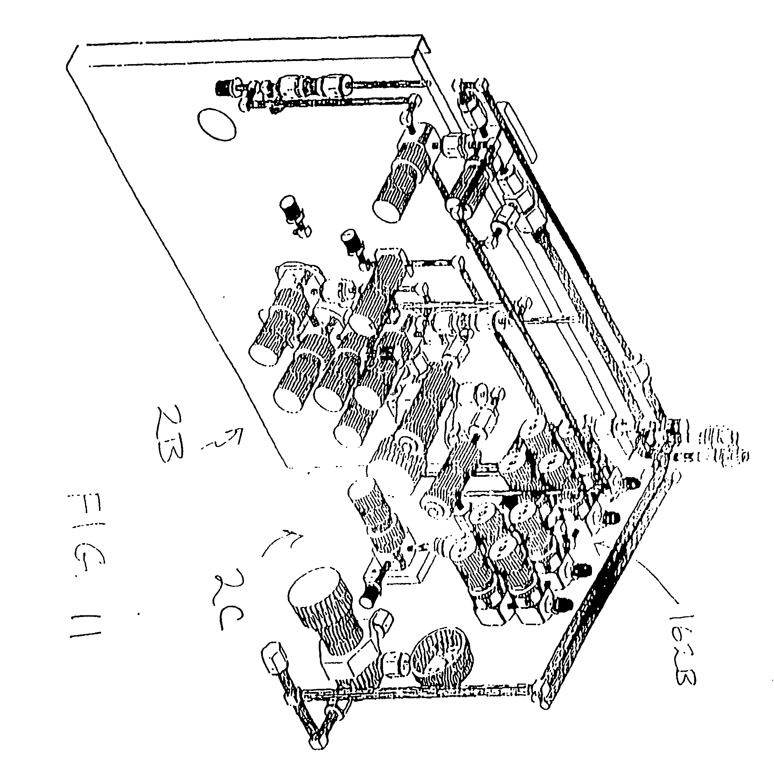

Referring again to FIG. 10 there is shown a non-limiting representative configuration of canisters and manifolds in the cabinet. In FIG. 10, first, second, and third refill canisters 110 A, 110C, and 110E provide chemicals to first, second, and third supply canisters 110B, 110D, and 110F. Each of the set of refill and supply canisters may contain the same chemical, with each set of canisters containing a different chemical. As shown in FIG. 1, each pair of supply and refill canisters may be connected to a supply and a refill manifold that form part of an overall manifold. In FIG. 10, three overall manifolds are employed, one manifold for each set of canisters. In FIG. 10, several details as depicted in FIG. 1 have been omitted for simplicity. In general it is seen that the cabinet includes supply (process) manifolds 2B, 3B, and 4B; refill manifolds 2C, 3C, and 4C which include four branch manifolds 162B, 163B, and 164B. FIG. 11 illustrates a three-dimensional representative view of certain components of the manifold 2A that could be mounted within a cabinet 310. As can be seen in FIG. 11, components of refill manifold 2B and supply manifold 2C are shown, including four branch supply manifold 162B, such as may be employed in FIG. 10.

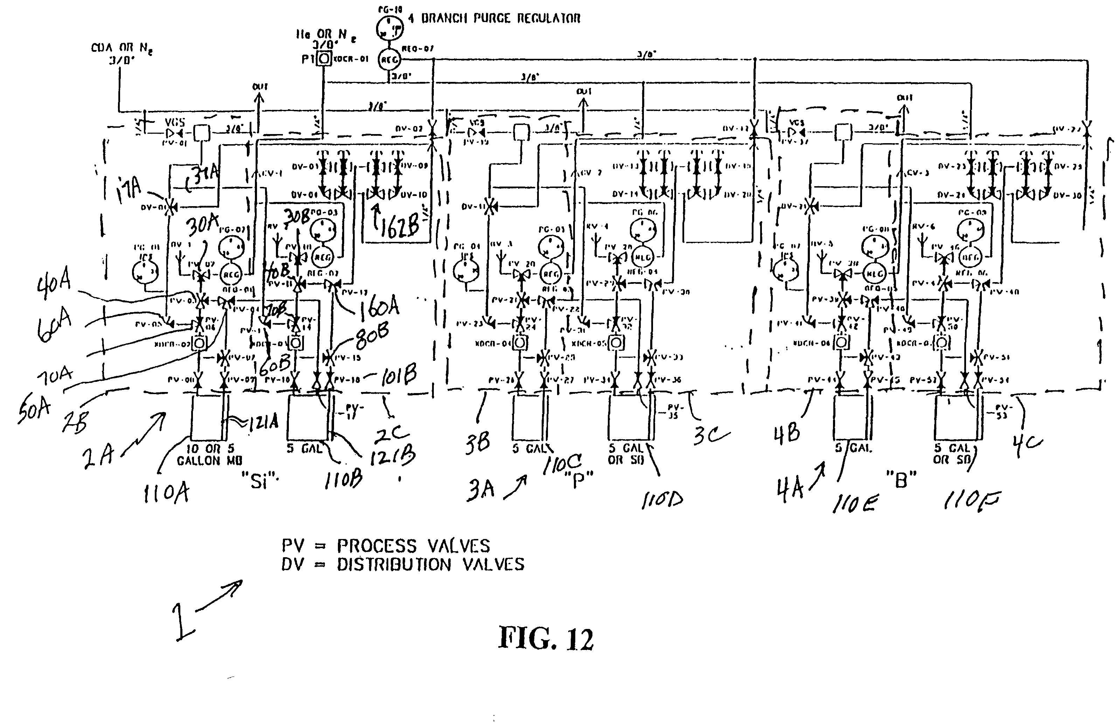

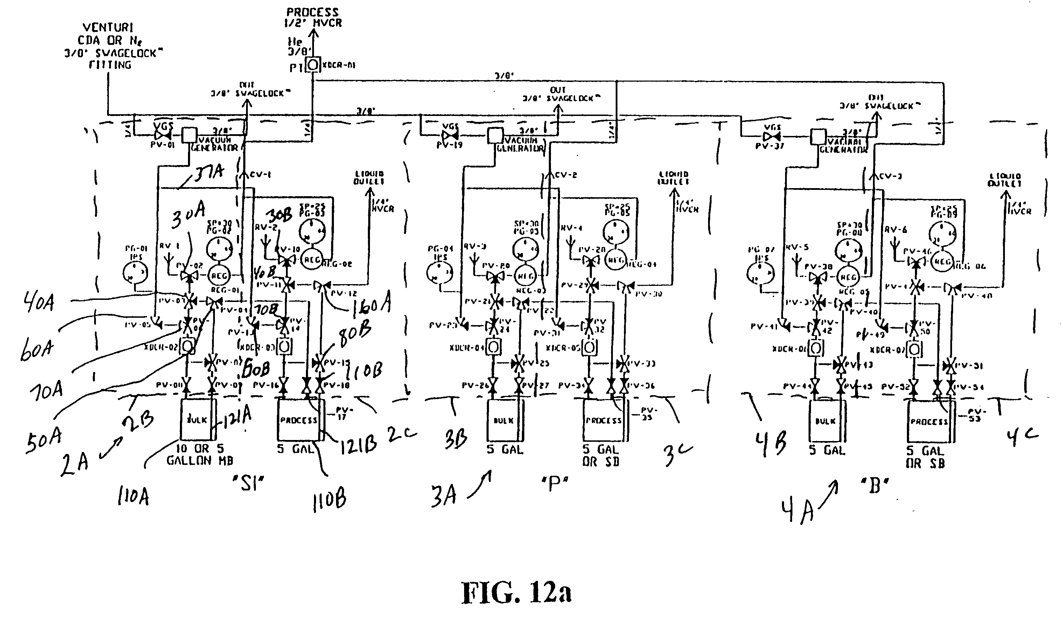

FIGS. 12 and 12a depict additional manifold and canister configurations for delivery of a plurality of chemicals to a process tool. FIGS. 12 and 12a are similar to FIG. 1, but are different in certain ways. The system 1 in FIGS. 12 and 12a includes valves and lines which have been numbered to correspond with those of FIG. 1, to the extent there is overlap. In FIG. 12 there is shown another representative, non-limiting example of a system configuration of this invention. FIG. 12 shows a system 1 that in general provides for refill and delivery of three chemicals.

The system configuration in FIG. 12 employs three essentially identical manifolds 2A, 3A, and 4A. By increasing head pressure in supply canister 110B, liquid chemical may be forced out through line 121B, CI 101B, four branch supply valve 160A to four branch supply manifold 162B from which chemical is distributed to one or more process tools. Output lines may be connected to any of the four exit ports of the four branch supply manifold 162B, with such output lines leading to a canister, a valve manifold box containing another four branch supply manifold, or a process tool. Chemical may be dispensed from supply canisters 110D and 110F by a similar procedure. Chemical may be delivered to a process tool by use of a pump that withdraws chemical from the supply canisters rather than pushing, mechanical pressure, via a pneumatic cylinder, or via a bag of chemical in a canister that has pressure applied to it, or via a bag in the canister which supplies the pressure as by filling the bag with gas or liquid. In FIG. 12, vacuum can be provided via line 37A, which ties in above valve 17A, through open valve 17A to the four branch manifold 162B while the four branch manifold continues to provide chemical. Vacuum may also be provided to the valving attached to canister 110B by opening valve 60B in 2C. It should be appreciated that the branched supply manifold 162B uses four branch valves, a supply manifold may use any number of valves. For instance, the branched supply manifold may employ two or more branch valves. Although there is no limit as to the number of branch valves in the branched supply manifold, typically the number of valves is 10 or less. It should be noted that the branched supply manifold is connected to and in communication with the process line. In FIG. 12, control valve 80B is connected to canister outlet 101B rather than inlet valve 100B as shown in FIG. 1. It may be appreciated that in FIG. 12 the valve configuration in 2C is substantially similar to the valve configuration in 2B, which is in contrast to the configuration shown in FIG. 1. Thus, in FIG. 12 while 2B employs valves 60A, 70A, 40A, 30A and 50A, 2C similarly employs valves 60B, 60B, 70B, 40B, 30B and 50B. In FIGS. 1, 12 and 12A, each of the process canisters (110B, 110D and 110F) has an outlet valve to which a dip tube is connected, an inlet valve through which chemical is provided to the process canister, and a third valve which serves to provide positive pressure or vacuum to the canister. The configuration of FIG. 12a is substantially similarly to FIG. 12 except that distribution manifolds 162B have been removed. This is particularly applicable to systems that supply small quantities of chemicals during a fabrication process, or if only a single tool is being fed chemicals. In both FIG. 12 and FIG. 12a, the system provides a source of silicon, phosphorous and boron.

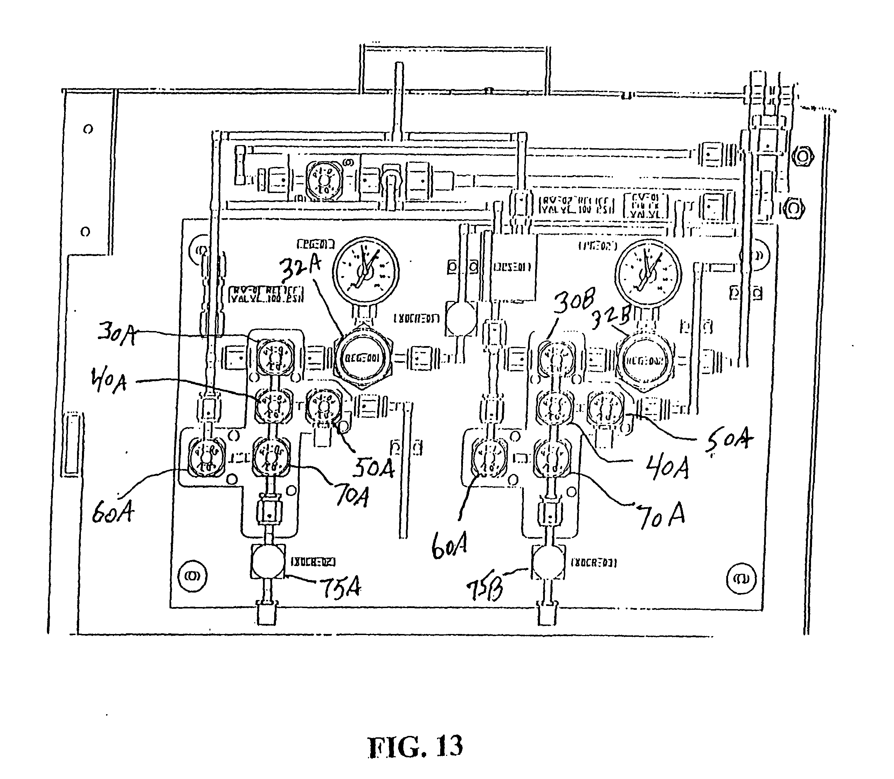

FIG 13 depicts one embodiment of a manifold used in the practice of this invention. This configuration is used in FIG. 12 and FIG. 12a. Thus, in FIG. 13, the manifold amounts to sections of 2B and 2C, for example, wherein the left side that connects to a refill canister includes valves 30A, 40A, 50A, 60A and 70A, and wherein the right side, which connects to a process canister, includes valves 30B, 40B, 50B, 60B and 70B. Each respective side also includes regulators 32A, 32B which serve to meter inert gas into the system and pressure transducers 75A and 75B which serve to monitor pressure.

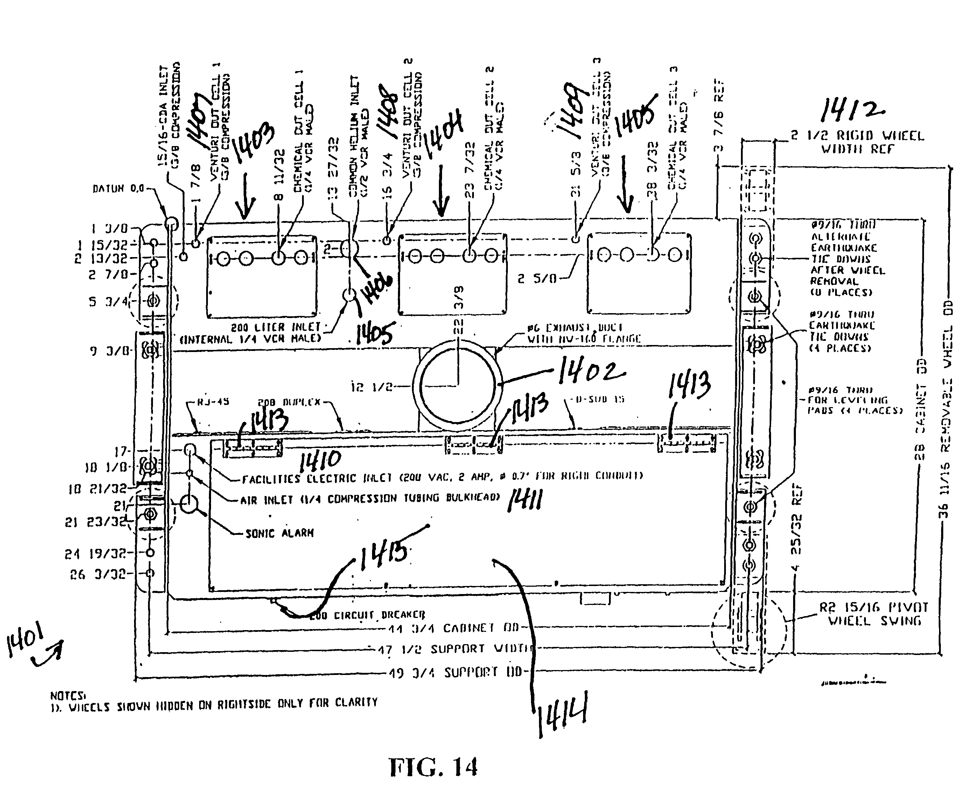

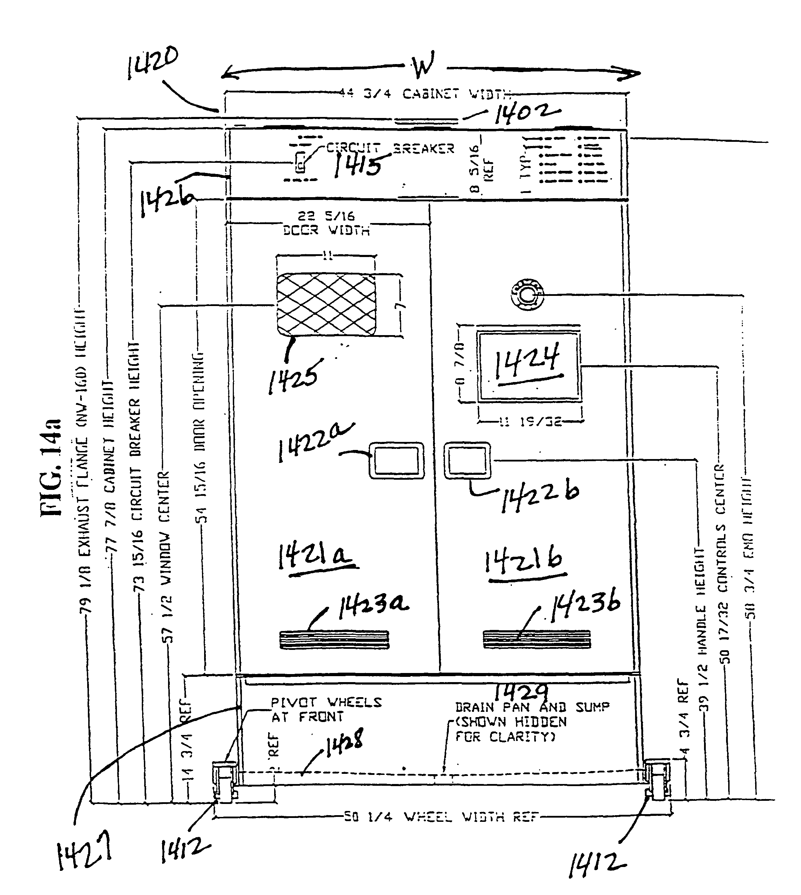

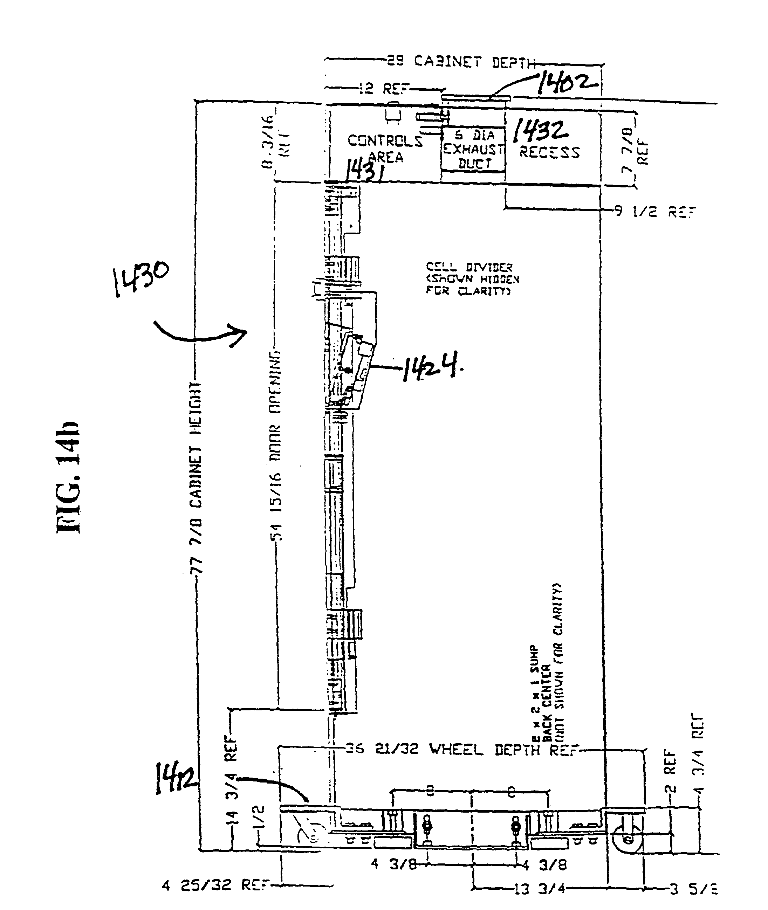

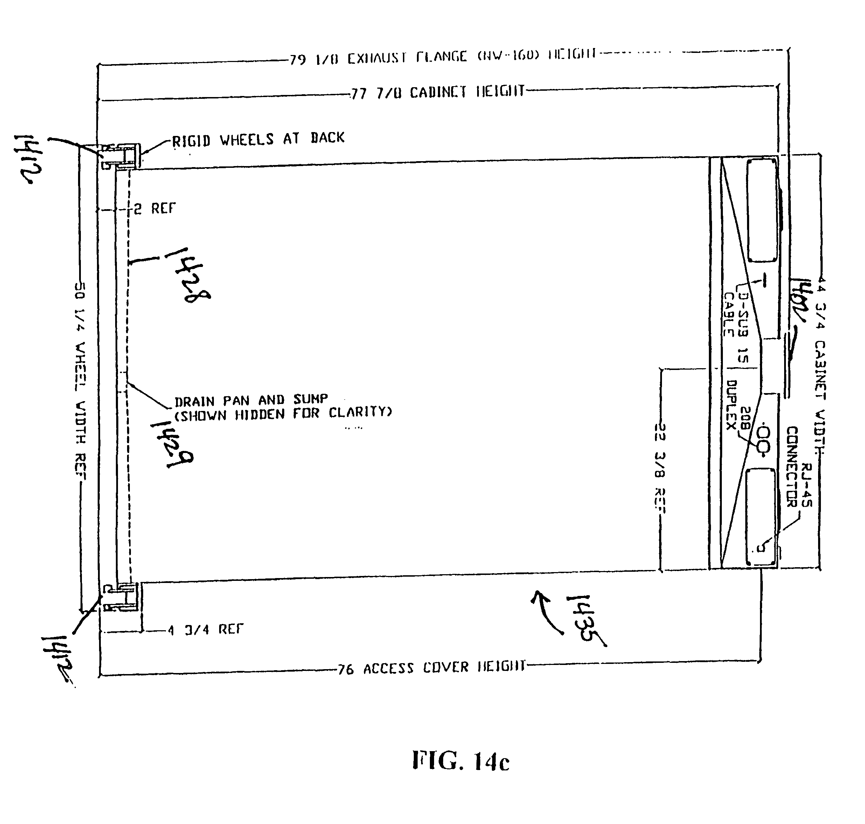

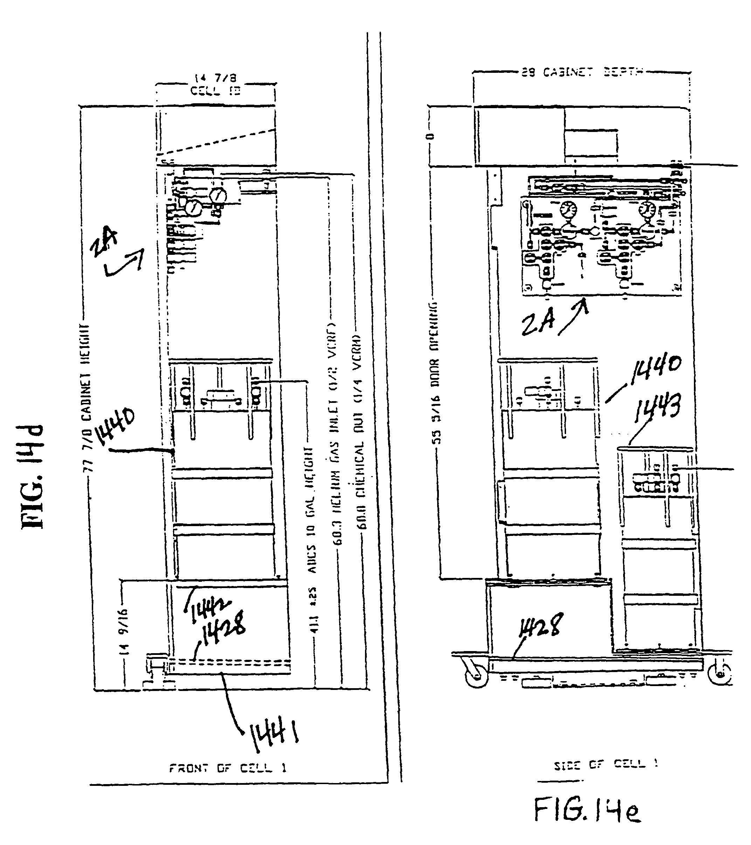

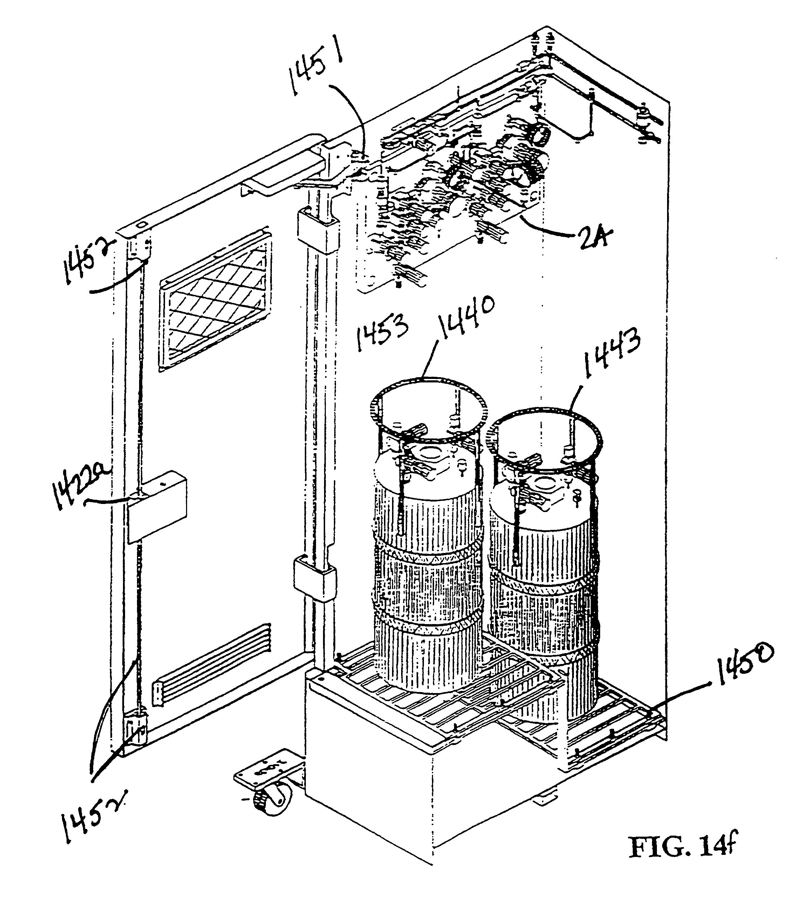

FIGS. 14, 14a, 14b, 14c, 14d, 14e and 14f depict various exterior, interior, and cutaway views of a cabinet used in the practice of this invention. FIG. 14 shows a representative top for a cabinet of this invention. The top 1401has dimensions appropriate to fit a given width and length of the cabinet. The top 1401 includes a duct 1402 which serves as an exit conduit for exhaust gases. Three groups of four holes 1403, 1404 and 1405 for distribution manifold outlet lines are included in the top. It is contemplated that the outlet lines (e.g., stainless steel tubing) connect to the distribution manifold and are guided through an appropriate hole, then connect to a process tool or the like. Similarly, the holes may be fitted with fittings (such as male VCR fittings) so that the outlet lines connect to the fittings and then additional lines to the process tool or the like connect to the male fitting on the exterior side of the top. If distribution manifolds are omitted, as in FIG. 12a, then less holes need be bored in the top or, if a top is used which already has multiple holes drilled as in the configuration depicted in FIG. 14, the holes may be capped to close the opening. The top may also include other holes or fittings such as an inlet for a bulk chemical canister 1405, for inert gas source 1406, for Venturi vacuum 1407, 1408 and 1409, for electrical inlets 1410, for air inlet 1411. In this upper view of the top 1401, there are also shown option items such as removable wheels 1412, and the wheels may also be on the left side of the top. The wheels would attach to the base but are shown here from this perspective view. Hinges 1413 serve to attach a section 1414 so that an operator can access the inside of the cabinet from the top. In this embodiment, a circuit breaker 1415 is also depicted, which would connect to internal electrical instrumentation.

FIG. 14a shows the front 1420 of the cabinet. The placement of wheels 1412 are readily seen in this view as being attached to the lower section of the cabinet. The width "W" of the cabinet will vary based on the size and number of canisters in the cabinet. For instance, in one embodiment, the cabinet is wide enough to house three canisters. In another embodiment, the cabinet is wide enough to house four canisters. In FIG. 14a, the duct 1402 protrudes from the top. Two doors 1421a, 1421 b form part of the front. The doors may be on spring loaded hinges for ease of entry. Handles 1422a, 1422b are included on the doors, as are vents 1423a, 1423b. A touch screen 1424 provides a means for inputting instructions for the control instrumentation (not shown). A small window 1425 allows an operator to observe the inside of the cabinet without opening the doors 1422a, 1422b. The front 1420 includes an upper area 1426 and a lower area 1427. The upper area 1426 provides additional space for manifolds, instrumentation and the like that may be included in the cabinet. The lower area 1427 typically provides an area above the canisters that serves as a safety containment area in the event of leakage. The containment area is commonly angled as depicted by phantom line 1428 so that liquid chemical may gravity feed toward drain pan 1429. A sump (not shown) may also be included to pump off liquid chemical from the drain pan 1429.

FIG. 14b is a side view of the cabinet showing one of the sides 1430. In this partial cutaway view, inner aspects of certain components are shown, including the touch screen 1424 and duct 1402. In this embodiment, an area 1431 defines an area that serves to house control instrumentation. A second recess area 1432 is also shown. FIG. 14c shows the back 1435 of the cabinet. The cabinet shown in FIGS. 14-14c has a cabinet width (excluding appendages such as wheels) of about 44.75 inches (about 114 cm), a depth of about 28 inches (about 71 cm) and a height with wheels to the duct of about 79 1/8 inches (about 198 cm). It should be appreciated that these dimensions may vary depending on the number and size of the canisters.

FIG. 14d and 14e depict front and side views of a pair of canisters seated in a cutaway portion of a cabinet. In FIG. 14d a canister 1440 sits in an elevated position above the bottom 1441 of the cabinet and may rest on a shelf 1442. The valves, regulators and tubing shown in the upper half of the cabinet correspond to manifold 2A of FIG. 1 or FIG. 12. Since this is a cutaway view, additional canister pairs would be housed in the remainder of the cabinet. In this sense, FIG. 14d shows a representative "cell" of the system. It should be appreciated that while a cabinet having 3 cells is depicted in FIG. 14d, additional cells may be included such that a cabinet houses 4 pairs of canisters, 5 pairs of canisters and so forth. FIG. 14e shows a side view of the canister pair. Here it is seen that the back canister 1443 sits on the floor of the cabinet. Each of canisters 1440 and 1443 may be attached to respective portions of manifold 2A by stainless steel tubing, not shown. An upraised canister 1440 facilitates easier change out of the canister for the operator. FIG. 14f shows a perspective view of canisters 1440 and 1443. In this view it is seen that canister 1443 may be seated on a shelf 1450 to raise it just above the very base of the cabinet. This view also shows more detail of the hinges 1451 that may be used to attach the door 1421a to left side 1453, as well as a locking mechanism 1452 for the door that connect to handle 1422a.

Further modifications and alternative embodiments of this invention will be apparent to those skilled in the art in view of this description. Accordingly, this description is to be construed as illustrative only and is for the purpose of teaching those skilled in the art the manner of carrying out the invention. It is to be understood that the forms of the invention herein shown and described are to be taken as presently preferred embodiments. Equivalent elements may be substituted for those illustrated and described herein, and certain features of the invention may be utilized independently of the use of other features, all as would be apparent to one skilled in the art after having the benefit of this description of the invention.

## Claims

1. A system (1) for delivering multiple different liquid chemicals to a process tool, comprising at least a first process canister (110B) for containing a first liquid chemical and a second process canister (110D) for containing a second liquid chemical, said system is further **characterized by**:
a first refill canister (110A) for containing the first liquid chemical, wherein said first refill canister (110A) and said first process canister (110B) are connected to a first manifold (2A) that connects to at least one first process line (121B), wherein the first refill canister (110A) is capable of refilling the first chemical to the first process canister (110B) through the first manifold (2A), and wherein the first process canister (110B) is capable of supplying the first chemical to the process tool;
a second refill canister (110C) for containing the second liquid chemical, wherein said second refill canister (110C) and said second process canister (110D) are connected to a second manifold (3A) that connects to at least one second process line, wherein the second refill canister (110C) is capable of refilling the second chemical to the second process canister (110D) through the second manifold (3A), and wherein the second process canister (110D) is capable of supplying the second chemical to the process tool;
wherein the first refill canister (110A), the first process canister (110B), the second refill canister (110C), the second process canister (110D) and the first (2A) and second (3A) manifolds are housed in a cabinet (310).

2. The system of claim I further comprising: a third refill canister (110E) for containing a third liquid chemical, and a third process canister (110F) for containing the third liquid chemical, wherein said third refill canister (110E) and said third process canister (110F) are connected to a third manifold (4A) that connects to at least one third process line, wherein the third refill canister (110E) is capable of refilling the third process canister (110F) through the third manifold (4A), and wherein the third refill canister (110E), the third process canister (110F), and the third manifold (4A) are housed in the cabinet (310).

3. The system of claim 2 further comprising a fourth refill canister for containing a fourth liquid chemical, and a fourth process canister for containing the fourth liquid chemical, wherein the fourth refill canister and the fourth process canister are connected to a fourth manifold that connects to at least one fourth process line, wherein the fourth refill canister is capable of refilling the fourth process canister through the fourth manifold, and wherein the fourth refill canister, the fourth process canister, and the fourth manifold are housed in the cabinet (310).

4. The system of claim 1, wherein the cabinet (310) houses a total of six or eight canisters.

5. The system of claim 1 wherein at least one of the manifolds comprises: a vacuum supply valve (10); a vacuum generator (14); a pressure vent valve (20); a gas inlet valve (30); a bypass valve (40); an isolation valve (50); a control valve (80); a canister inlet valve (90); a canister outlet valve (100); and a canister inlet coupler; wherein the vacuum supply valve (10) is connected to the vacuum generator (14); wherein the vacuum generator (14) is connected to the pressure vent valve (20) and the control valve (80); wherein the gas inlet valve (30) is connected to pressure vent valve (20) and bypass valve (40); wherein the bypass valve (40) is further connected to isolation valve (50) and the canister inlet valve (90); wherein the isolation valve (50) is also connected to canister outlet valve (100); wherein canister inlet valve (50) is connected to control valve (80), and canister outlet valve (100).

6. The system of claim 1 wherein at least one manifold of the system comprises: a vacuum supply valve (10) connected to a vacuum generator (14); a pressure vent valve (20) connected to the vacuum generator (14) and to a gas inlet valve (30); a control valve (60) connected to vacuum generator (14); wherein the gas inlet valve (30) is also connected to a bypass valve (40), an isolation valve (50) connected to a canister outlet valve (100) and to the bypass valve (40), and a canister inlet valve (90) connected to the bypass valve (40), the control valve (60), and a canister outlet valve (100).

7. The system of claim 2 wherein the first refill canister (110A) contains tetraethylorthosilicate; wherein the second refill canister (110C) contains triethylphosphate or triethylphosphate; and wherein the third refill canister (110E) contains triethylborate.

8. The system of claim 1 wherein the cabinet (310) is composed of two sides (312 and 314), a back (318), a top (320), a base (340) and a front (316) having at least one door (330B), wherein the base (340) optionally has wheels (1412) attached, wherein at least one of the at least one door (330B) has a touch screen (1424).

9. The system of claim 8 wherein the cabinet (310) includes an angled containment floor (1428) that directs chemical to a drain pan (1429).

10. A method for manufacturing a system for delivery of multiple different liquid chemicals from a first process canister (110B), a second process canister (110D) and a third process canister (110F), said method is **characterized by**:
connecting a first refill canister (110A) and the first process canister (110B) to a first manifold (2A) that connects to at least one first process line (121B), wherein the first refill canister (110A) refills a first liquid chemical to the first process canister (110B) through the first manifold (2A), and wherein the first process canister (110B) supplies the first liquid chemical to the process tool;
connecting a second refill canister (110C) and the second process canister (110D) to a second manifold (3A) that connects to at least one second process line, wherein the second refill canister (110C) refills a second liquid chemical to the second process canister (110D) through the second manifold (3A), and wherein the second process canister (110D) supplies the second liquid chemical to the process tool;
connecting a third refill canister (110E) and the third process canister (110F) to a third manifold (4A) that connects to at least one third process line, wherein the third refill canister (110E) refills a third liquid chemical to the third process canister (110F) through the third manifold (4A), and wherein the third process canister (110F) supplies the third liquid chemical to the process tool; and
housing the first refill canister (110A), the first process canister (110B), the second refill canister (110C), the second process canister (110D), the third refill canister (110E), the third process canister (110F), and the first (2A), second (3A) and third (4A) manifolds in a cabinet (310).

11. The method of claim 10 further comprising connecting a fourth refill canister and a fourth process canister to a fourth manifold that connects to at least one fourth process line, wherein the fourth refill canister refills the fourth process canister through the fourth manifold, and wherein the fourth refill canister, the fourth process canister, and the fourth manifold are housed in the cabinet (310).

12. The method of claim 10 wherein at least one of the manifolds comprises: a vacuum supply valve (10); a vacuum generator (14); a pressure vent valve (20); a gas inlet valve (30); a bypass valve (40); an isolation valve (50); a control valve (80); a canister inlet valve (90); a canister outlet valve (100); and a canister inlet coupler; wherein the vacuum supply valve (10) is connected to the vacuum generator (14); wherein the vacuum generator (14) is connected to the pressure vent valve (20) and the control valve (80); wherein the gas inlet valve (30) is connected to pressure vent valve (20) and bypass valve (40); wherein the bypass valve (40) is further connected to isolation valve (50) and the canister inlet valve (90); wherein the isolation valve (50) is also connected to canister outlet valve (100); wherein canister inlet valve (90) is connected to control valve (80), and canister outlet valve (100).

13. The method of claim 10 wherein at least one manifold of the system comprises:
a vacuum supply valve (10) connected to a vacuum generator (14); a pressure vent valve (20) connected to the vacuum generator (14) and to a gas inlet valve (30); a control valve (60) connected to vacuum generator (14);
wherein the gas inlet valve (30) is also connected to a bypass valve (40), an isolation valve (50) connected to a canister outlet valve (100) and to the bypass valve (40), and a canister inlet valve (90) connected to the bypass valve (40), the control valve (60), and a canister outlet valve (100).

14. The method of claim 10 wherein the first liquid chemical is tetraethylorthosilicate; wherein the second liquid chemical is triethylphosphate or triethylphosphite; and wherein the third liquid chemical is triethylborate.

15. The method of claim 10 wherein the cabinet (310) is composed of two sides (312 and 314), a back (318), a top (310), a base (340) and a front (316) having at least one door (330B), wherein the base (340) optionally has wheels (1412) attached, wherein at least one of the at least one door (330B) has a touch screen (1424).

16. The method of claim IS wherein the cabinet (310) includes an angled containment floor (1428) that directs chemical to a drain pan (1429).

17. A method for supplying a first, a second, and a third liquid chemicals to a process tool from a system that comprises at least a first process canister (110B), a second process canister (110D), and a third process canister (110E), said method is further **characterized by**:
a first refill canister (110A), wherein said first refill canister (110A) and said first process canister (110B) are connected to a first manifold (2A) that connects to at least one first process line (121B), wherein the first refill canister (110A) is capable of refilling the first liquid chemical to the first process canister (110B) through the first manifold (2A), and wherein the first process canister (110B) is capable of supplying the first liquid chemical to the process tool;
a second refill canister (110C), wherein said second refill canister (110C) and said second process canister (110D) are connected to a second manifold (3A) that connects to at least one second process line, wherein the second refill canister (110C) is capable of refilling the second liquid chemical to the second process canister (110D) through the second manifold (3A), and wherein the second process canister (110D) is capable of supplying the second liquid chemical to the process tool;
a third refill canister (110E), wherein said third refill canister (110E) and said third process canister (110F) are connected to a third manifold (4A) that connects to at least one third process line, wherein the third refill canister (110E) is capable of refilling the third liquid chemical to the third process canister (110F) through the third manifold (4A), and wherein the third process canister (110F) is capable of supplying the third liquid chemical to the process tool;
wherein the first refill canister (110A), the first process canister (110B), the second refill canister (110C), the second process canister (110D), the third refill canister (110E), the third process canister (110F), and the first (2A), second (3A) and third (4A) manifolds are housed in a cabinet (310).

18. The method of claim 17 further comprising a fourth refill canister and a fourth process canister that are connected to a fourth manifold that connects to at least one fourth process line, wherein the fourth refill canister is capable of refilling the fourth process canister through the fourth manifold, and wherein the fourth refill canister, the fourth process canister, and the fourth manifold are housed in the cabinet (310).

19. The method of claim 17 wherein the cabinet (310) houses a total of six or eight canisters.

20. The method of claim 17 wherein at least one of the manifolds comprises: a vacuum supply valve (10); a vacuum generator (14); a pressure vent valve (20); a gas inlet valve (30); a bypass valve (40); an isolation valve (50); a control valve (80); a canister inlet valve (90); a canister outlet valve (100); and a canister inlet coupler; wherein the vacuum supply valve (10) is connected to the vacuum generator (14); wherein the vacuum generator (14) is connected to the pressure vent valve (20) and the control valve (80); wherein the gas inlet valve (30) is connected to pressure vent valve (20) and bypass valve (40); wherein the bypass valve (40) is further connected to isolation valve (50) and the canister inlet valve (90); wherein the isolation valve (50) is also connected to canister outlet valve (100); wherein canister inlet valve (90) is connected to control valve (80), and canister outlet valve (100).

21. The method of claim 17 wherein at least one manifold of the system comprises:
a vacuum supply valve (10) connected to a vacuum generator (14); a pressure vent valve (20) connected to the vacuum generator (14) and to a gas inlet valve (30); a control valve (60) connected to vacuum generator (14); wherein the gas inlet valve (30) is also connected to a bypass valve (40), an isolation valve (50) connected to a canister outlet (100) valve and to the bypass valve (40), and a canister inlet valve (90) connected to the bypass valve (40), the control valve (60), and a canister outlet valve (100).

22. The method of claim 17 wherein the first liquid chemical is tetraethylorthosilicate; wherein the second liquid chemical is triethylphosphate or triethylphosphite; and wherein the third liquid chemical is triethylborate.

23. The method of claim 17 wherein the cabinet (310) is composed of two sides (312 and 314), a back (318), a top (320), a base (340) and a front (316) having at least one door (330B), wherein the base (340) optionally has wheels (1412) attached, wherein at least one of the at least one door (330B) has a touch screen (1424)).

24. The method of claim 23 wherein the cabinet (310) includes an angled containment floor (1428) that directs chemical to a drain pan (1429).

## Patentansprüche

1. System (1) zum Zuführen von mehreren, unterschiedlichen, flüssigen Chemikalien zu einer Prozessvorrichtung, mit zumindest einem ersten Prozesskanister (110B) zum Aufbewahren einer ersten flüssigen Chemikalie und einem zweiten Prozesskanister (110D) zum Aufbewahren einer zweiten flüssigen Chemikalie, wobei das System ferner **gekennzeichnet ist durch**:
einen erster Nachfüllkanister (110A) zum Aufbewahren der ersten flüssigen Chemikalie, wobei der erste Nachfüllkanister (110A) und der erste Prozesskanister (110B) mit einem ersten Verteiler (2A) verbunden sind, der zumindest mit einer ersten Prozessleitung (121B) verbunden ist, wobei mittels des ersten Nachfüllkanisters (110A) die erste Chemikalie **durch** den ersten Verteiler (2A) in den ersten Prozesskanister (110B) nachfüllbar ist, und wobei mittels des ersten Prozesskanisters (110B) die erste Chemikalie der Prozessvorrichtung zuführbar ist,
einen zweiter Nachfüllkanister (110C) zum Aufbewahren der zweiten flüssigen Chemikalie, wobei der zweite Nachfüllkanister (110C) und der zweite Prozesskanister (110D) mit einem zweiten Verteiler (3A) verbunden sind, der mit zumindest einer zweiten Prozessleitung verbunden ist, wobei mittels des zweiten Nachfüllkanister (110C) die zweite Chemikalie **durch** den zweiten Verteiler (3A) in den zweiten Prozesskanister (110D) nachfüllbar ist, und wobei mittels des zweiten Prozesskanisters (110D) die zweite Chemikalie der Prozessvorrichtung zuführbar ist,
wobei der erste Nachfüllkanister (110A), der erste Prozesskanister (110B), der zweite Nachfüllkanister (110C), der zweite Prozesskanister (110D) und der erste (2A) und der zweite (3A) Verteiler in einem Schrank (310) untergebracht sind.

2. System nach Anspruch 1, ferner aufweisend: einen dritten Nachfüllkanister (110E) zum Aufbewahren einer dritten flüssigen Chemikalie, und einen dritten Prozesskanister (110F) zum Aufbewahren der dritten flüssigen Chemikalie, wobei der dritte Nachfüllkanister (110E) und der dritte Prozesskanister (110F) mit einem dritten Verteiler (4A)verbunden sind, der zumindest mit einer dritten Prozessleitung verbunden ist, wobei mittels des dritten Nachfüllkanisters (110E) durch den dritten Verteiler (4A) der dritten Prozesskanister (110F) nachfüllbar ist, und wobei der dritte Nachfüllkanister (110E), der dritte Prozesskanister (110F), und der dritte Verteiler (4A) in dem Schrank (310) untergebracht sind.

3. System nach Anspruch 2, ferner aufweisend: einen vierten Nachfüllkanister zum Aufbewahren einer vierten flüssigen Chemikalie und einem vierten Prozesskanister zum Aufbewahren der vierten flüssigen Chemikalie, wobei der vierte Nachfüllkanister und der vierte Prozesskanister mit einem vierten Verteiler verbunden sind, der zumindest mit einer vierten Prozessleitung verbunden ist, wobei mittels des vierten Nachfüllkanisters durch den vierten Verteiler der vierten Prozesskanister nachfüllbar ist, und wobei der vierte Nachfüllkanister, der vierte Prozesskanister und der vierte Verteiler in dem Schrank (310) untergebracht sind.

4. System nach Anspruch 1, wobei in dem Schrank (310) eine Gesamtmenge von sechs oder acht Kanistern untergebracht ist.

5. System nach Anspruch 1, wobei zumindest einer der Verteiler aufweist: ein Unterdruck-Zuführventil (10), einen Unterdruck-Generator (14), ein Druck-Ablassventil (20), ein Gas-Einlassventil (30), ein Bypassventil (40), ein Absperrventil (50), ein Steuerventil (80), ein Kanister-Einlassventil (90), ein Kanister-Auslassventil (100) und eine Kanister-Einlasskupplung, wobei das Unterdruck-Zuführventil (10) mit dem Unterdruck-Generator (14) verbunden ist, wobei der Unterdruck-Generator (14) mit dem Druck-Ablassventil (20) und dem Steuerventil (80) verbunden ist, wobei das Gas-Einlassventil (30) mit dem Druck-Ablassventil (20) und dem Bypassventil (40) verbunden ist, wobei das Bypassventil (40) ferner mit dem Absperrventil (50) und dem Kanister-Einlassventil (90) verbunden ist, wobei das Absperrventil (50) auch mit dem Kanister-Auslassventil (100) verbunden ist, wobei das Kanister-Einlassventil (50) mit dem Steuerventil (80) und dem Kanister-Auslassventil (100) verbunden ist.

6. System nach Anspruch 1, wobei zumindest ein Verteiler des Systems aufweist: ein mit einem Unterdruck-Generator (14) verbundenes Unterdruck-Zuführventil (10), ein mit dem Unterdruck-Generator (14) und mit einem Gas-Einlassventil (30) verbundenes Druck-Ablassventil (20), ein mit dem Unterdruck-Generator (14) verbundenes Steuerventil (60), wobei das Gas-Einlassventil (30) auch mit einem Bypassventil (40) verbunden ist, ein mit einem Kanister-Auslassventil (100) und mit dem Bypassventil (40) verbundenes Absperrventil (50) und ein mit dem Bypassventil (40), dem Steuerventil (60) und einem Kanister-Auslassventil (100) verbundenes Kanister-Einlassventil (90).

7. System nach Anspruch 2, wobei der erste Nachfüllkanister (110A) Tetraethylorthosilikat enthält, wobei der zweite Nachfüllkanister (110C) Triethylphosphat oder Triethylphosphat enthält und wobei der dritte Nachfüllkanister (110E) Triethylborat enthält.

8. System nach Anspruch 1, wobei der Schrank (310) aus zwei Seiten (312 und 314), einer Rückseite (318), einer Oberseite (320), einem Sockel (340) und einer Vorderseite (316) mit zumindest einer Tür (330b) zusammengesetzt ist, wobei an dem Sockel (340) optional Räder (1412) angebracht sind und zumindest eine der zumindest einen Tür (330b) einen Touch-Screen (1424) aufweist.

9. System nach Anspruch 8, wobei der Schrank (310) einen abgewinkelten Auffangbehälterboden (1428) aufweist, der eine Chemikalie zu einer Ablaufwanne (1429) leitet.

10. Verfahren zum Herstellen eines Systems für die Zufuhr von mehreren, unterschiedlichen, flüssigen Chemikalien aus einem ersten Prozesskanister (110B), einem zweiten Prozesskanister (110D) und einem dritten Prozesskanister (110F), wobei das Verfahren **dadurch gekennzeichnet ist, dass**: ein erster Nachfüllkanister (110A) und ein erster Prozesskanister (110B) mit einem ersten Verteiler (2A) verbunden werden, der zumindest mit einer ersten Prozessleitung (121b) verbunden ist, wobei der erste Nachfüllkanister (110A) eine erste flüssige Chemikalie durch den ersten Verteiler (2A) in den ersten Prozesskanister (110B) nachfüllt, und wobei der erste Prozesskanister (110B) die erste flüssige Chemikalie der Prozessvorrichtung zuführt,
ein zweiter Nachfüllkanister (110C) und der zweite Prozesskanister (110D) mit einem zweiten Verteiler (3A) verbunden werden, der zumindest mit einer zweiten Prozessleitung verbunden ist, wobei der zweite Nachfüllkanister (110C) eine zweite flüssige Chemikalie durch den zweiten Verteiler (3A) in den zweiten Prozesskanister (110D) nachfüllt, und wobei der zweite Prozesskanister (110D) die zweite flüssige Chemikalie der Prozessvorrichtung zuführt,
ein dritter Nachfüllkanister (110E) und der dritte Prozesskanister (110F) mit einem dritten Verteiler (4A) verbunden werden, der zumindest mit einer dritten Prozessleitung verbunden ist, wobei der dritte Nachfüllkanister (110E) eine dritte flüssige Chemikalie durch den dritten Verteiler (4A) in den dritten Prozesskanister (110F) nachfüllt, und wobei der dritte Prozesskanister (110F) die dritte flüssige Chemikalie der Prozessvorrichtung zuführt,
und der erste Nachfüllkanister (110A), der erste Prozesskanister (110B), der zweite Nachfüllkanister (110C), der zweite Prozesskanister (110D), der dritte Nachfüllkanister (110E), der dritte Prozesskanister (110F) und der erste (2A), der zweite (3A) und der dritte (4A) Verteiler in einem Schrank (310) untergebracht werden.

11. Verfahren nach Anspruch 10, ferner aufweisend: Verbinden eines vierten Nachfüllkanisters und eines vierten Prozesskanisters mit einem vierten Verteiler, der zumindest mit einer vierten Prozessleitung verbunden ist, wobei der vierte Nachfüllkanister durch den vierten Verteiler den vierten Prozesskanister nachfüllt, und wobei der vierte Nachfüllkanister, der vierte Prozesskanister und der vierte Verteiler in dem Schrank (310) untergebracht werden.

12. Verfahren nach Anspruch 10, wobei zumindest einer der Verteiler aufweist: ein Unterdruck-Zuführventil (10), einen Unterdruck-Generator (14), ein Druck-Ablassventil (20), ein Gas-Einlassventil (30), ein Bypassventil (40), ein Absperrventil (50), ein Steuerventil (80), ein Kanister-Einlassventil (90), ein Kanister-Auslassventil (100) und eine Kanister-Einlasskupplung, wobei das Unterdruck-Zuführventil (10) mit dem Unterdruck-Generator (14) verbunden wird, wobei der Unterdruck-Generator (14) mit dem Druck-Ablassventil (20) und dem Steuerventil (80) verbunden wird, wobei das Gas-Einlassventil (30) mit dem Druck-Ablassventil (20) und dem Bypassventil (40) verbunden wird, wobei das Bypassventil (40) ferner mit dem Absperrventil (50) und dem Kanister-Einlassventil (90) verbunden wird, wobei das Absperrventil (50) auch mit dem Kanister-Auslassventil (100) verbunden wird, wobei das Kanister-Einlassventil (90) mit dem Steuerventil (80) und dem Kanister-Auslassventil (100) verbunden wird.

13. Verfahren nach Anspruch 10, wobei zumindest ein Verteiler des Systems aufweist: ein mit dem Unterdruck-Generator (14) verbundenes Unterdruck-Zuführventil (10), ein mit dem Unterdruck-Generator (14) und dem Gas-Einlassventil (30) verbundenes Druck-Ablassventil (20), ein mit dem Unterdruck-Generator (14) verbundenes Steuerventil (60), wobei das Gas-Einlassventil (30) auch mit dem Bypassventil (40) verbunden wird, ein mit einem Kanister-Auslassventil (100) und einem Bypassventil (40) verbundenes Absperrventil (50) und ein mit dem Bypassventil (40), dem Steuerventil (60) und einem Kanister-Auslassventil (100) verbundenes Kanister-Auslassventil (90).

14. Verfahren nach Anspruch 10, wobei die erste flüssige Chemikalie Tetraethylorthosilicat ist, wobei die zweite flüssige Chemikalie Triethylphosphat oder Triethylphosphid ist und wobei die dritte flüssige Chemikalie Triethylborat ist.

15. Verfahren nach Anspruch 10, wobei der Schrank (310) aus zwei Seiten (312 und 314), einer Rückseite (318), einer Oberseite (310), einem Sockel (340) und einer Vorderseite (316) zusammengesetzt wird, die zumindest eine Tür (330B) hat, wobei an dem Sockel (340) optional Räder (1412) angebracht sind und zumindest eine der zumindest einen Tür (330B) einen Touch-Screen (1424) aufweist.

16. Verfahren nach Anspruch 15, wobei der Schrank (310) einen abgewinkelten Auffangbehälterboden (1428) aufweist, der Chemikalien zu einer Ablaufwanne (1429) leitet.

17. Verfahren zum Zuführen einer ersten, einer zweiten und einer dritten flüssigen Chemikalie zu einer Prozessvorrichtung von einem System, das zumindest einen ersten Prozesskanister(110B), einen zweiten Prozesskanister (110D) und eine dritten Prozesskanister (110E) aufweist, wobei das Verfahren ferner **gekennzeichnet ist durch**:
einen ersten Nachfüllkanister (110A), wobei der erste Nachfüllkanister (110A) und der erste Prozesskanister (110B) mit einem ersten Verteiler (2A) verbunden sind, der zumindest mit einer ersten Prozessleitung (121B) verbunden ist, wobei mittels des ersten Nachfüllkanisters (110A) die erste flüssige Chemikalie **durch** den ersten Verteiler (2A) in den ersten Prozesskanister (110B) nachfüllbar ist, und wobei mittels des ersten Prozesskanisters (110B) die erste flüssige Chemikalie der Prozessvorrichtung zuführbar ist,
einen zweiten Nachfüllkanister (110C), wobei der zweite Nachfüllkanister (110C) und der zweite Prozesskanister (110D) mit einem zweiten Verteiler (3A) verbunden sind, der zumindest mit einer zweiten Prozessleitung verbunden ist, wobei mittels des zweiten Nachfüllkanisters (110C) die zweite flüssige Chemikalie **durch** den zweiten Verteiler (3A) in den zweiten Prozesskanister (110D) nachfüllbar ist, und wobei mittels des zweiten Prozesskanisters (110D) die zweite flüssige Chemikalie der Prozessvorrichtung zuführbar ist,
einen dritten Nachfüllkanister (110E), wobei der dritte Nachfüllkanister (110E) und der dritte Prozesskanister (110F) mit einem dritten Verteiler (4A) verbunden sind, der zumindest mit einer dritten Prozessleitung verbunden ist, wobei mittels des dritten Nachfüllkanisters (110E) die dritte flüssige Chemikalie **durch** den dritten Verteiler (4A) in den dritten Prozesskanister (110F) nachfüllbar ist, und wobei mittels des dritten Prozesskanisters (110F) die dritte flüssige Chemikalie der Prozessvorrichtung zuführbar ist,
wobei der erste Nachfüllkanister (110A), der erste Prozesskanister (110B), der zweite Nachfüllkanister (110C), der zweite Prozesskanister (110D), der dritte Nachfüllkanister (110E), der dritte Prozesskanister (110F) und der erste (2A), der zweite (3A) und der dritte (4A) Verteiler in einem Schrank (310) untergebracht sind.

18. Verfahren nach Anspruch 17 ferner aufweisend: einen vierten Nachfüllkanister und einen vierten Prozesskanister, die mit einem vierten Verteiler verbunden sind, der zumindest mit einer vierten Prozessleitung verbunden ist, wobei mittels des vierten Nachfüllkanisters durch den vierten Verteiler der vierte Prozesskanister nachfüllbar ist, und wobei der vierte Nachfüllkanister, der vierte Prozesskanister und der vierte Verteiler in dem Schrank (310) untergebracht sind.

19. Verfahren nach Anspruch 17, wobei in dem Schrank (310) eine Gesamtmenge von 6 oder 8 Kanistern untergebracht ist.

20. Verfahren nach Anspruch 17, wobei zumindest einer der Verteiler aufweist: ein Unterdruck-Zuführventil (10), einen Unterdruck-Generator (14), ein Druck-Ablassventil (20), ein Gas-Einlassventil (30), ein Bypassventil (40), ein Absperrventil (50), ein Steuerventil (80), ein Kanister-Einlassventil (90), ein Kanister-Auslassventil (100) und eine Kanister-Einlasskupplung, wobei das Unterdruck-Zuführventil (10) mit dem Unterdruck-Generator (14) verbunden ist, wobei der Unterdruck-Generator (14) mit dem Druck-Ablassventil (20) und dem Steuerventil (80) verbunden ist, wobei das Gas-Einlassventil (30) mit dem Druck-Ablassventil (20) und dem Bypassventil (40) verbunden ist, wobei das Bypassventil (40) mit dem Absperrventil (50) und dem Kanister-Einlassventil (90) verbunden ist, wobei das Absperrventil (50) auch mit dem Kanister-Auslassventil (100) verbunden ist, wobei das Kanister-Einlassventil (90) mit dem Steuerventil (80) und dem Kanister-Auslassventil (100) verbunden ist.

21. Verfahren nach Anspruch 17, wobei zumindest ein Verteiler des Systems aufweist: ein mit einem Unterdruck-Generator (14) verbundenes Unterdruck-Zuführventil (10), ein mit dem Unterdruck-Generator (14) und einem Gas-Einlassventil (30) verbundenes Druck-Ablassventil (20), ein mit dem Unterdruck-Generator (14) verbundenes Steuerventil (60), wobei das Gas-Einlassventil (30) auch mit einem Bypassventil (40) verbunden ist, ein mit einem Kanister-Auslassventil (100) und einem Bypassventil (40) verbundenes Absperrventil (50) und ein mit einem Bypassventil (40), einem Steuerventil (60) und einem Kanister-Auslassventil (100) verbundenes Kanister-Einlassventil (90).

22. Verfahren nach Anspruch 17, wobei die erste flüssige Chemikalie Tetraethylorthosilicat ist, wobei die zweite flüssige Chemikalie Triethylphosphat oder Triethylphosphid ist und wobei die dritte flüssige Chemikalie Triethylborat ist.

23. Verfahren nach Anspruch 17, wobei der Schrank (310) aus zwei Seiten (312 und 314), einer Rückseite (318), einer Oberseite (320), einem Sockel (340) und einer Vorderseite (316) zusammengesetzt ist, die zumindest eine Tür (330B) hat, wobei an der Bodenseite (340) optional Räder (1412) angebracht sind und zumindest eine der zumindest einen Tür (330B) einen Touch-Screen (1424) aufweist.

24. Verfahren nach Anspruch 23, wobei der Schrank (310) einen abgewinkelten Auffangbehälterboden (1428) aufweist, der Chemikalien zu einer Ablaufwanne (1429) leitet.

## Revendications

1. Système (1) pour délivrer de multiples produits chimiques liquides différents à un outil de traitement, comprenant au moins un premier récipient de traitement (110B) pour contenir un premier produit chimique liquide et un deuxième récipient de traitement (110D) pour contenir un deuxième produit chimique liquide, ledit système étant en outre **caractérisé par** :
un premier récipient de réapprovisionnement (110A) pour contenir le premier produit chimique liquide, dans lequel ledit premier récipient de réapprovisionnement (110A) et ledit premier récipient de traitement (110B) sont raccordés à un premier collecteur (2A) qui se raccorde à au moins une première conduite de traitement (121B), dans lequel le premier récipient de réapprovisionnement (110A) est capable de réapprovisionner en premier produit chimique le premier récipient de traitement (110B) via le premier collecteur (2A), et dans lequel le premier récipient de traitement (110B) est capable de délivrer le premier produit chimique à l'outil de traitement;
un deuxième récipient de réapprovisionnement (110C) pour contenir le deuxième produit chimique, dans lequel ledit deuxième récipient de réapprovisionnement (110C) et ledit deuxième récipient de traitement (110D) sont raccordés à un deuxième collecteur (3A) qui se raccorde à une deuxième conduite de traitement, dans lequel le deuxième récipient de réapprovisionnement (110C) est capable de réapprovisionner en deuxième produit chimique le deuxième récipient de traitement (110D) via le deuxième collecteur (3A) et dans lequel le deuxième récipient de traitement (110D) est capable de délivrer le deuxième produit chimique à l'outil de traitement;
dans lequel le premier récipient de réapprovisionnement (110A), le premier récipient de traitement (110B), le deuxième récipient de réapprovisionnement (110C), le deuxième récipient de traitement (110D) et les premier (2A) et deuxième (3A) collecteurs sont logés dans une armoire (310).

2. Système selon la revendication 1, comprenant en outre un troisième récipient de réapprovisionnement (110E) pour contenir un troisième produit chimique liquide et un troisième récipient de traitement (110F) pour contenir le troisième produit chimique liquide, dans lequel ledit troisième récipient de réapprovisionnement (110E) et ledit troisième récipient de traitement (110F) sont raccordés à un troisième collecteur (4A) qui se raccorde à au moins une troisième conduite de traitement, dans lequel ledit troisième récipient de réapprovisionnement (110E) est capable de réapprovisionner le troisième récipient de traitement (110F) via le troisième collecteur (4A), et dans lequel le troisième récipient de réapprovisionnement (110E), le troisième récipient de traitement (110F) et le troisième collecteur (4A) sont logés dans l'armoire (310).

3. Système selon la revendication 2, comprenant en outre un quatrième récipient de réapprovisionnement pour contenir un quatrième produit chimique et un quatrième récipient de traitement pour contenir le quatrième produit chimique liquide, dans lequel le quatrième récipient de réapprovisionnement et le quatrième récipient de traitement sont raccordés à un quatrième collecteur qui se raccorde à au moins une quatrième conduite de traitement, dans lequel le quatrième récipient de réapprovisionnement est capable de réapprovisionner le quatrième récipient de traitement via le quatrième collecteur et dans lequel le quatrième récipient de réapprovisionnement, le quatrième récipient de traitement et le quatrième collecteur sont logés dans l'armoire (310).

4. Système selon la revendication 1, dans lequel l'armoire (310) loge un total de six ou huit récipients.

5. Système selon la revendication 1, dans lequel au moins un des collecteurs comprend une soupape d'application de vide (10); un générateur de vide (14); une soupape d'échappement de pression (20); une soupape d'entrée de gaz (30); une soupape de contournement (40); une soupape d'isolement (50); une soupape de commande (80); une soupape d'entrée de récipient (90); une soupape de sortie de récipient (100) et un coupleur d'entrée de récipient; dans lequel la soupape d'application de vide (10) est raccordée au générateur de vide (14); dans lequel le générateur de vide (14) est raccordé à la soupape d'échappement de pression (20) et à la soupape de commande (80); dans lequel la soupape d'entrée de gaz (30) est raccordée à la soupape d'échappement de pression (20) et à la soupape de contournement (40); dans lequel la soupape de contournement (40) est en outre raccordée à la soupape d'isolement (50) et à la soupape d'entrée de récipient (90); dans lequel la soupape d'isolement (50) est également raccordée à la soupape de sortie de récipient (100); dans lequel la soupape d'entrée de récipient (50) est raccordée à la soupape de commande (80) et à la soupape de sortie de récipient (100).

6. Système selon la revendication 1, dans lequel au moins un collecteur du système comprend une soupape d'application de vide (10) raccordée à un générateur de vide (14); une soupape d'échappement de pression (20) raccordée au générateur de vide (14) et à une soupape d'entrée de gaz (30); une soupape de commande (60) raccordée au générateur de vide (14); dans lequel la soupape d'entrée de gaz (30) est également raccordée à une soupape de contournement (40), une soupape d'isolement (50) raccordée à une soupape de sortie de récipient (100) et à la soupape de contournement (40) et une soupape d'entrée de récipient (90) raccordée à la soupape de contournement (40), à la soupape de commande (60) et à une soupape de sortie de récipient (100).

7. Système selon la revendication 2, dans lequel le premier récipient de réapprovisionnement (110A) contient de l'orthosilicate de tétraéthyle; dans lequel le deuxième récipient de réapprovisionnement (110C) contient du phosphate de triéthyle ou du phosphate de triéthyle; et dans lequel le troisième récipient de réapprovisionnement (110E) contient du borate de triéthyle.

8. Système selon la revendication 1, dans lequel l'armoire (310) est composée de deux côtés (312 et 314), d'une partie arrière (318), d'une partie supérieure (320), d'une base (340) et d'une face (316) ayant au moins une porte (330B), dans lequel la base (340) a éventuellement des roues (1412) fixées et dans lequel au moins une de la au moins une porte (330B) a un écran tactile (1424).

9. Système selon la revendication 8, dans lequel l'armoire (310) comprend un plancher de confinement incliné (1428) qui dirige le produit chimique vers un bac de drainage (1429).

10. Procédé de fabrication d'un système pour délivrer de multiples produits chimiques liquides différents à partir d'un premier récipient de traitement (110B), d'un deuxième récipient de traitement (110D) et d'un troisième récipient de traitement (110F), ledit procédé est **caractérisé par** les étapes suivantes :
le raccordement d'un premier récipient de réapprovisionnement (110A) et du premier récipient de traitement (110B) à un premier collecteur (2A) qui est raccordé à au moins une première conduite de traitement (121B), dans lequel le premier récipient de réapprovisionnement (110A) réapprovisionne en produit chimique liquide le premier récipient de traitement (110B) via le premier collecteur (2A) et dans lequel le premier récipient de traitement (110B) délivre le premier produit chimique liquide à l'outil de traitement;
le raccordement d'un deuxième récipient de réapprovisionnement (110C) et du deuxième récipient de traitement (110D) à un deuxième collecteur (3A) qui est raccordé à au moins une deuxième conduite de traitement, dans lequel le deuxième récipient de réapprovisionnement (110C) réapprovisionne en deuxième produit chimique le deuxième récipient de traitement (110D) via le deuxième collecteur (3A), et dans lequel le deuxième récipient de traitement (110D) délivre le deuxième produit chimique liquide à l'outil de traitement;
le raccordement d'un troisième récipient de réapprovisionnement (110E) et du troisième récipient de traitement (110F) à un troisième collecteur (4A) qui est raccordé à au moins une troisième conduite de traitement, dans lequel le troisième récipient de réapprovisionnement (110E) réapprovisionne en troisième produit chimique le troisième récipient de traitement (110F) via le troisième collecteur (4A), et dans lequel le troisième récipient de traitement (110F) délivre le troisième produit chimique liquide à l'outil de traitement; et
le logement du premier récipient de réapprovisionnement (110A), du premier récipient de traitement (110B), du deuxième récipient de réapprovisionnement (110C), du deuxième récipient de traitement (110D), du troisième récipient de réapprovisionnement (110E), du troisième récipient de traitement (110F) et les premier (2A), deuxième (3A) et troisième (4A) collecteurs dans une armoire (310).

11. Procédé selon la revendication 10, comprenant en outre le raccordement d'un quatrième récipient de réapprovisionnement et d'un quatrième récipient de traitement à un quatrième collecteur qui est raccordé à au moins une quatrième conduite de traitement, dans lequel le quatrième récipient de réapprovisionnement réapprovisionne le quatrième récipient de traitement via le quatrième collecteur et dans lequel le quatrième récipient de réapprovisionnement, le quatrième récipient de traitement et le quatrième collecteur sont logés dans l'armoire (310).

12. Procédé selon la revendication 10, dans lequel au moins l'un des collecteurs comprend une soupape d'application de vide (10); un générateur de vide (14); une soupape d'échappement de pression (20); une soupape d'entrée de gaz (30); une soupape de contournement (40); une soupape d'isolement (50); une soupape de commande (80); une soupape d'entrée de récipient (90); une soupape de sortie de récipient (100); et un coupleur d'entrée de récipient; dans lequel la soupape d'application de vide (10) est raccordée au générateur de vide (14); dans lequel le générateur de vide (14) est raccordé à la soupape d'échappement de pression (20) et à la soupape de commande (80); dans lequel la soupape d'entrée de gaz (30) est raccordée à la soupape d'échappement de pression (20) et à la soupape de contournement (40); dans lequel la soupape de contournement (40) est en outre raccordée à la soupape d'isolement (50) et à la soupape d'entrée de récipient (90); dans lequel la soupape d'isolement (50) est également raccordée à la soupape de sortie de récipient (100); dans lequel la soupape d'entrée de récipient (50) est raccordée à la soupape de commande (80) et à la soupape de sortie de récipient (100).

13. Procédé selon la revendication 10, dans lequel au moins un collecteur du système comprend :
une soupape d'application de vide (10) raccordée à un générateur de vide (14); une soupape d'échappement de pression (20) raccordée au générateur de vide (14) et à une soupape d'entrée de gaz (30); une soupape de commande (60) raccordée au générateur de vide (14);
dans lequel la soupape d'entrée de gaz (30) est également raccordée à une soupape de contournement (40), une soupape d'isolement (50) raccordée à une soupape de sortie de récipient (100) et à la soupape de contournement (40), et une soupape d'entrée de récipient (90) raccordée à la soupape de contoumement (40), à la soupape de commande (60) et à une soupape de sortie de récipient (100).

14. Procédé selon la revendication 10, dans lequel le premier produit chimique liquide est de l'orthosilicate de tétraéthyle; dans lequel le deuxième produit chimique liquide est du phosphate de triéthyle ou du phosphite de triéthyle; et dans lequel le troisième produit chimique liquide est du borate de triéthyle.

15. Procédé selon la revendication 10, dans lequel l'armoire (310) est composée de deux côtés (312 et 314), d'une partie arrière (318), d'une partie supérieure (320), d'une base (340) et d'une face (316) ayant au moins une porte (330B), dans lequel la base (340) a éventuellement des roues (1412) fixées, dans lequel au moins une de la au moins une porte (330B) a un écran tactile (1424).

16. Procédé selon la revendication 15, dans lequel l'armoire (310) comprend un plancher de confinement incliné (1428) qui dirige le produit chimique vers un bac de drainage (1429).

17. Procédé pour acheminer un premier, un deuxième et un troisième produit chimique à un outil de traitement à partir d'un système qui comprend au moins un premier récipient de traitement (110B), un deuxième récipient de traitement (110D) et un troisième récipient de traitement (110E), ledit procédé étant en outre **caractérisé par** :
un premier récipient de réapprovisionnement (110A), dans lequel ledit premier récipient de réapprovisionnement (110A) et ledit premier récipient de traitement (110B) sont raccordées à un premier collecteur (2A) qui est raccordé à au moins une première conduite de traitement (121B), dans lequel le premier récipient de réapprovisionnement (110A) est capable de réapprovisionner en premier produit chimique le premier récipient de traitement (110B) via le premier collecteur (2A), et dans lequel le premier récipient de traitement (110B) est capable de délivrer le premier produit chimique à l'outil de traitement;
un deuxième récipient de réapprovisionnement (110C), dans lequel ledit deuxième récipient de réapprovisionnement (110C) et ledit deuxième récipient de traitement (110D) sont raccordés à un deuxième collecteur (3A) qui est raccordé à au moins une deuxième conduite de traitement, dans lequel le deuxième récipient de réapprovisionnement (110C) est capable de réapprovisionner en deuxième produit chimique le deuxième récipient de traitement (110D) via le deuxième collecteur (3A), et dans lequel le deuxième récipient de traitement (110D) est capable de délivrer le deuxième produit chimique à l'outil de traitement;
un troisième récipient de réapprovisionnement (110E), dans lequel ledit troisième récipient de réapprovisionnement (110E) et ledit troisième récipient de traitement (110F) sont raccordés à un troisième collecteur (4A) qui est raccordé à au moins une troisième conduite de traitement, dans lequel le troisième récipient de réapprovisionnement (110E) est capable de réapprovisionner en troisième produit chimique liquide le troisième récipient (110F) via le troisième collecteur (4A), et dans lequel le troisième récipient de traitement (110F) est capable de délivrer le troisième produit chimique liquide à l'outil de traitement;
dans lequel le premier récipient de réapprovisionnement (110A), le premier récipient de traitement (110B), le deuxième récipient de réapprovisionnement (110C), le deuxième récipient de traitement (110D), le troisième récipient de réapprovisionnement (110E), le troisième récipient de traitement (110F) et les premier (2A), deuxième (3A) et troisième (4A) collecteurs sont logés dans une armoire (310).

18. Procédé selon la revendication 17, comprenant en outre un quatrième récipient de réapprovisionnement et un quatrième récipient de traitement qui sont raccordés à un quatrième collecteur qui est raccordé à au moins une quatrième conduite de traitement, dans lequel le quatrième récipient de réapprovisionnement est capable de réapprovisionner le quatrième récipient de traitement via le quatrième collecteur, et dans lequel le quatrième récipient de réapprovisionnement, le quatrième récipient de traitement et le quatrième collecteur sont logés dans l'armoire (310).

19. Procédé selon la revendication 17, dans lequel l'armoire (310) loge un total de six ou huit récipients.

20. Procédé selon la revendication 17, dans lequel au moins un des collecteurs comprend une soupape d'application de vide (10); un générateur de vide (14); une soupape d'échappement de pression (20); une soupape d'entrée de gaz (30); une soupape de contournement (40); une soupape d'isolement (50); une soupape de commande (80); une soupape d'entrée de récipient (90); une soupape de sortie de récipient (100); et un coupleur d'entrée de récipient; dans lequel la soupape d'application de vide (10) est raccordée au générateur de vide (14); dans lequel le générateur de vide (14) est raccordé à la soupape d'échappement de pression (20) et à la soupape de commande (80); dans lequel la soupape d'entrée de gaz (30) est raccordée à la soupape d'échappement de pression (20) et à la soupape de contournement (40); dans lequel la soupape de contournement (40) est en outre raccordée à la soupape d'isolement (50) et à la soupape d'entrée de récipient (90); dans lequel la soupape d'isolement (50) est également raccordée à la soupape de sortie de récipient; dans lequel la soupape d'entrée de récipient (90) est raccordée à la soupape de commande (80) et à la soupape de sortie de récipient (100).

21. Procédé selon la revendication 17, dans lequel au moins un collecteur du système comprend :
une soupape d'application de vide (10) raccordée à un générateur de vide (14); une soupape d'échappement de pression (20) raccordé au générateur de vide (14) et à une soupape d'entrée de gaz (30); une soupape de commande (60) raccordée au générateur de vide (14); dans lequel la soupape d'entrée de récipient (30) est également raccordée à une soupape de contournement (40), une soupape d'isolement (50) raccordée à une soupape de sortie de récipient (100) et à la soupape de contoumement (40), et une soupape d'entrée de récipient (90) raccordée à la soupape de contournement (40), à la soupape de commande (80) et à la soupape de sortie de récipient (100).

22. Procédé selon la revendication 17, dans lequel le premier produit chimique liquide est de l'orthosilicate de tétraéthyle; dans lequel le deuxième produit chimique liquide est du phosphate de triéthyle ou du phosphite de triéthyle; et dans lequel le troisième produit chimique liquide est du borate de triéthyle.

23. Procédé selon la revendication 17, dans lequel l'armoire (310) est composée de deux côtés (312 et 314), d'une partie arrière (318), d'une partie supérieure (320), d'une base (340) et d'une face (316) ayant au moins une porte (330B), dans lequel la base (340) a éventuellement des roues (1412) fixées, dans lequel au moins une de la au moins une porte (330B) a un écran tactile (1424).

24. Procédé selon la revendication 23, dans lequel l'armoire (310) comprend un plancher de confinement incliné (1428) qui dirige le produit chimique vers un bac de drainage (1429).
